(19)

Europäisches Patentamt
European Patent Office
Office européen des brevets

(11) **EP 4 401 425 A1**

(12) **EUROPEAN PATENT APPLICATION**
published in accordance with Art. 153(4) EPC

(43) Date of publication:
**17.07.2024 Bulletin 2024/29**

(21) Application number: **22952310.5**

(22) Date of filing: **27.07.2022**

(51) International Patent Classification (IPC):
**H04R 17/02** (2006.01)    **H04R 9/02** (2006.01)

(52) Cooperative Patent Classification (CPC):
**B06B 1/0603; G10K 9/121; H04R 17/00;**
**H04R 17/005; H10N 30/2041; H10N 30/2042**

(86) International application number:
**PCT/CN2022/108205**

(87) International publication number:
**WO 2024/020846 (01.02.2024 Gazette 2024/05)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Shenzhen Shokz Co., Ltd.**
**Shenzhen, Guangdong 518108 (CN)**

(72) Inventors:
• **CUI, Chaojie**
  **Shenzhen, Guangdong 518108 (CN)**
• **ZHU, Guangyuan**
  **Shenzhen, Guangdong 518108 (CN)**

(74) Representative: **Wang, Bo**
  **Panovision IP**
  **Ebersberger Straße 3**
  **85570 Markt Schwaben (DE)**

(54) **ACOUSTIC OUTPUT DEVICE**

(57)    The present disclosure provides an acoustic output apparatus, comprising: a vibration element, the vibration element including a beam structure extending in a length direction, and the beam structure including: a piezoelectric layer configured to deform in response to an electrical signal, the deformation driving the vibration element to vibrate; and a mass element, the mass element being connected to a first position of the beam structure, the vibration of the vibration element driving the mass element to vibrate in a direction perpendicular to the length direction, wherein a ratio between a distance from the first position to one end of the beam structure and a length of the beam structure is in a range from 0.3 to 0.95 along the length direction of the beam structure.

FIG. 1

**Description**

**TECHNICAL FIELD**

The present disclosure relates to the field of acoustics, and in particular to an acoustic output apparatus.

**BACKGROUND**

The acoustic output apparatus driven by a piezoelectric material may generate vibrations based on the inverse piezoelectric effect of the piezoelectric materials to radiate sound waves outward. Compared with traditional electromagnetic acoustic output apparatus, the acoustic output apparatus driven by the piezoelectric material has higher electromechanical conversion efficiency, lower energy consumption, smaller size, and higher integration.

However, compared with the traditional electromagnetic acoustic output apparatus, the acoustic output apparatus driven by the piezoelectric material has poorer sound quality due to problems such as many vibration modes in the target frequency range, which cannot generate a smooth frequency response curve.

Therefore, it is desirable to provide an acoustic output apparatus that can generate a smoother frequency response curve in the target frequency range.

**SUMMARY**

The embodiments of the present disclosure provide an acoustic output apparatus, comprising a vibration element. The vibration element may include a beam structure extending in a length direction. The beam structure may include a piezoelectric layer configured to deform in response to an electrical signal. The deformation may drive the vibration element to vibrate. The beam structure may include a mass element. The mass element may be connected to a first position of the beam structure, and the vibration of the vibration element may drive the mass element to vibrate in a direction perpendicular to the length direction. A ratio between a distance from the first position to one end of the beam structure and a length of the beam structure may be in a range from 0.3 to 0.95 along the length direction of the beam structure.

In some embodiments, the vibration of the mass element may include a first resonance peak and a second resonance peak in a range from 50 Hz to 10000 Hz.

In some embodiments, an amplitude difference between a minimum frequency response between the first resonance peak and the second resonance peak and the first resonance peak or the second resonance peak may be less than 40 dB.

In some embodiments, the beam structure may include a fixed end and a free end.

In some embodiments, the acoustic output apparatus may further include a second mass element. The second mass element may be connected to the free end.

In some embodiments, a ratio between a mass of the mass element and a mass of the beam structure may be in a range from 0 to 1.2.

In some embodiments, a ratio between a distance from the first position to the fixed end and a length of the beam structure may be in a range from 0.7 to 0.95.

In some embodiments, a ratio between a frequency of the second resonance peak and a frequency of the first resonance peak may be greater than 17.

In some embodiments, the vibration of the mass element may include a third resonance peak. An amplitude difference between a minimum frequency response between the second resonance peak and the third resonance peak and the second resonance peak or the third resonance peak may be less than 30 dB.

In some embodiments, a ratio between a frequency of the third resonance peak and a frequency of the second resonance peak may be greater than 4.

In some embodiments, a ratio between a distance from the first position to the fixed end and a length of the beam structure may be in a range from 0.45 to 0.6.

In some embodiments, the beam structure may include two fixed ends.

In some embodiments, a ratio between a distance from the first position to one of the two fixed ends and a length of the beam structure may be in a range from 0.3 to 0.4.

In some embodiments, a ratio of a frequency of the second resonance peak to a frequency of the first resonance peak may be greater than 13.

In some embodiments, the vibration of the mass element may include a third resonance peak. An amplitude difference between a minimum frequency response between the second resonance peak and the third resonance peak and the second resonance peak or the third resonance peak may be less than 40 dB.

In some embodiments, a ratio of a frequency of the third resonance peak to a frequency of the second resonance peak may be greater than 2.

In some embodiments, a ratio between a distance from the first position to one of the two fixed ends and a length of the beam structure may be in a range from 0.45 to 0.5.

In some embodiments, a ratio between a distance from the first position to one side of the beam structure and a width of the beam structure in a width direction of the beam structure may be in a range from 0.15 to 0.3.

In some embodiments, the beam structure may include a fixed end and a hinged-support end. During the vibration of the vibration element, the hinged-support end may rotate along an axis perpendicular to the length direction and the vibration direction of the beam structure.

In some embodiments, a ratio between a distance from the first position to the fixed end and the length of the beam structure may be in a range from 0.5 to 0.6.

In some embodiments, a ratio between a frequency of the second resonance peak and a frequency of the first resonance peak may be greater than 6.

In some embodiments, the beam structure may include two hinged-support ends. During the vibration of the vibration element, the two hinged-support ends may rotate along an axis perpendicular to the length direction and the vibration direction of the beam structure, respectively.

In some embodiments, a ratio between a distance from the first position to one of the two hinged-support ends and the length of the beam structure may be in a range from 0.3 to 0.4.

In some embodiments, a ratio of a frequency of the second resonance peak to a frequency of the first resonance peak may be greater than 10.

In some embodiments, the beam structure may include two elastic ends. The two elastic ends may be elastically connected to a fixed support of the acoustic output apparatus via elastic members, respectively.

In some embodiments, the beam structure may be a symmetrical structure at both ends. The elastic members corresponding to the two elastic ends may be disposed symmetrically along the length direction or the width direction of the beam structure.

In some embodiments, a frequency range of the first resonance peak may be in a range from 300 Hz to 700 Hz.

In some embodiments, a ratio between a distance from the first position to one of the two elastic ends and the length of the beam structure may be in a range from 0.1 to 0.25.

In some embodiments, the acoustic output apparatus may further include: a third vibration element. The third vibration element may include a third beam structure. One end of the beam structure and one end of the third beam structure may be fixed ends, and the other end of the beam structure may be connected to the other end of the third beam structure through an elastic connection member.

In some embodiments, a count of the vibration elements may be two or more. The beam structure of each of the two or more vibration elements may include a fixed end and a free end.

In some embodiments, the mass element may be respectively connected to the first position of the beam structure of each of the two or more vibration elements. A ratio between a distance from the first position of each beam structure to the fixed end of the beam structure and the length of the beam structure may be in a range from 0.7 to 0.95.

**BRIEF DESCRIPTION OF THE DRAWINGS**

FIG. 1 is a block diagram illustrating an exemplary acoustic output apparatus according to some embodiments of the present disclosure;

FIG. 2 is a schematic diagram illustrating an exemplary beam structure according to some embodiments of the present disclosure;

FIG. 3 is a graph illustrating vibration response curves of a beam structure at different points according to some embodiments of the present disclosure;

FIG. 4 is a schematic diagram illustrating an exemplary structure of a beam structure according to some embodiments of the present disclosure;

FIG. 5 is a graph illustrating vibration response curves of a beam structure at different points along a length direction of the beam structure when the beam structure is with or without a load according to some embodiments of the present disclosure;

FIG. 6 is a graph illustrating a relationship between a ratio of a mass of a second mass element to a mass of a beam structure and a ratio of a distance from a first position to a fixed end to a length of the beam structure according to some embodiments of the present disclosure;

FIG. 7 is a schematic diagram illustrating an exemplary structure of a beam structure according to some embodiments of the present disclosure;

FIG. 8 is a schematic diagram illustrating an exemplary structure of a hinged-support end according to some embodiments of the present disclosure;

FIG. 9 is a schematic diagram illustrating an exemplary structure of a beam structure according to some embodiments of the present disclosure;

FIG. 10 is a schematic diagram illustrating an exemplary beam structure according to some embodiments of the present disclosure;

FIG. 11A is a schematic diagram illustrating an exemplary structure of a beam structure according to some embodiments of the present disclosure;

FIG. 11B is a schematic diagram illustrating vibration modes of the beam structure in FIG. 11A;

FIG. 12 is a graph illustrating vibration response curves of a beam structure at different points along a length direction of the beam structure according to some embodiments of the present disclosure;

FIG. 13 is a graph illustrating vibration response curves of a beam structure at different position points along a width direction of the beam structure according to some embodiments of the present disclosure;

FIG. 14A is a schematic diagram illustrating an exemplary structure of a beam structure according to some embodiments of the present disclosure;

FIG. 14B is a schematic diagram illustrating vibration modes of the beam structure in FIG. 14A;

FIG. 15 is a graph illustrating vibration response curves of a beam structure at different points on the beam structure according to some embodiments of the present disclosure;

FIG. 16A is a schematic diagram illustrating an exemplary structure of a beam structure according to some embodiments of the present disclosure;

FIG. 16B is a schematic diagram illustrating vibration modes of the beam structure in FIG. 16A;

FIG. 17 is a graph illustrating vibration response curves of a beam structure at different points on the beam structure according to some embodiments of the present disclosure;

FIG. 18 is a partial schematic diagram illustrating an acoustic output apparatus according to some embodiments of the present disclosure;

FIG. 19 is a schematic diagram illustrating an acoustic output apparatus according to some embodiments of the present disclosure.

## DETAILED DESCRIPTION

In order to illustrate the technical solutions of the embodiments of the present disclosure more clearly, the following will briefly introduce the drawings that need to be used in the description of the embodiments. Obviously, the drawings in the following description are only some examples or embodiments of the present disclosure. For those of ordinary skill in the art, without creative work, the present disclosure can be applied to other similar scenarios according to these drawings. Unless it is obvious from the language environment or otherwise stated, the same reference numbers in the drawings represent the same structure or operation.

It should be understood that the terms "system", "apparatus", "unit", "component", "module" and/or "block" may be a method that is used herein to distinguish different components, elements, parts, sections, or assemblies at different levels. However, the terms may be replaced by other expressions if they serve the same purpose.

As used in the present disclosure and the appended claims, the singular forms "a," "an," and "the" include plural referents unless the content clearly dictates otherwise. In general, the terms "comprise," "comprises," and/or "comprising," "include," "includes," and/or "including," merely prompt to include steps and elements that have been clearly identified, and these steps and elements do not constitute an exclusive listing. The methods or devices may also include other steps or elements.

Embodiments of the present disclosure describe an acoustic output apparatus, the acoustic output apparatus may include a vibration element. The vibration element may include a beam structure extending in a length direction. In some embodiments, the beam structure may include a piezoelectric layer. The piezoelectric layer may deform in response to an electrical signal due to the inverse piezoelectric effect. The deformation may drive the vibration element to vibrate. In some embodiments, the acoustic output apparatus may further include a mass element connected to a first position of the beam structure, and the vibration of the vibration element may drive the mass element to vibrate in a direction perpendicular to the length direction of the beam structure, thereby producing a sound. In some embodiments, the mass element may be connected to the beam structure at different positions along the length direction of the beam structure such that vibration modes output by the mass element may be different. Accordingly, the frequency response curves of the acoustic output apparatus may be different. In such cases, a suitable first position of the connected mass element may be determined on the beam structure such that the frequency response curves of the acoustic output apparatus may be smoother. According to the embodiments of the present disclosure, the first position may be determined (e.g., by adjusting a ratio between a distance from the first position to one end of the beam structure and the length of the beam structure) such that the frequency response curve of the acoustic output apparatus may have no or less resonance valley in a target frequency range (e.g., 50 Hz-10,000 Hz) or an amplitude difference between a resonance peak(s) and a resonance valley(s) may be reduced. In such cases, a smoother frequency response curve may be obtained, which may improve the sound quality of the acoustic output apparatus.

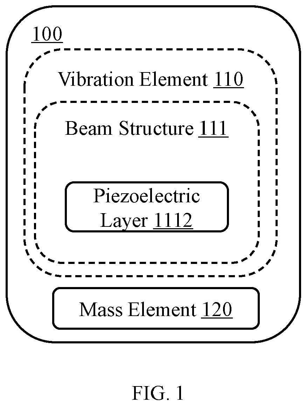

FIG. 1 is a block diagram illustrating an exemplary acoustic output apparatus according to some embodiments of the present disclosure. As shown in FIG. 1, the acoustic output apparatus 100 may include a vibration element 110 and a mass element 120.

The acoustic output apparatus 100 may be configured to convert an audio signal (e.g., an electrical signal containing acoustic information) into an acoustic signal. In some embodiments, the acoustic output apparatus 100 may be a bone-conduction acoustic output apparatus, an air-conduction acoustic output apparatus, or an acoustic output apparatus combined with bone and air conduction. In some embodiments, the acoustic output apparatus 100 may be implemented as a pair of glasses, a smart bracelet, a headphone, a hearing aid, a smart helmet, a smart watch, a smart clothing, a smart backpack, a smart accessory, or the like, or any combination thereof. For example, the acoustic output apparatus 100 may be a pair of functional myopia glasses, a pair of reading glasses, a pair of cycling glasses, or a pair of sunglasses, etc., and may also be a pair of intelligent glasses (e.g., a pair of audio glasses with earphone function). In some embodiments, the acoustic output apparatus 100 may also be applied to a head-mounted apparatus such as a helmet, an Augmented Reality (AR) apparatus, a Virtual Reality (VR) apparatus, etc. In some embodiments, the augmented reality apparatus or virtual reality apparatus may include a virtual reality headset, a pair of virtual reality glass, an augmented reality helmet, a pair of augmented reality glasses, or the like, or any combination thereof, for example, the virtual reality apparatus and/or the augmented reality apparatus may include a Google Glass, an Oculus Rift, a Hololen, a Gear VR, etc.

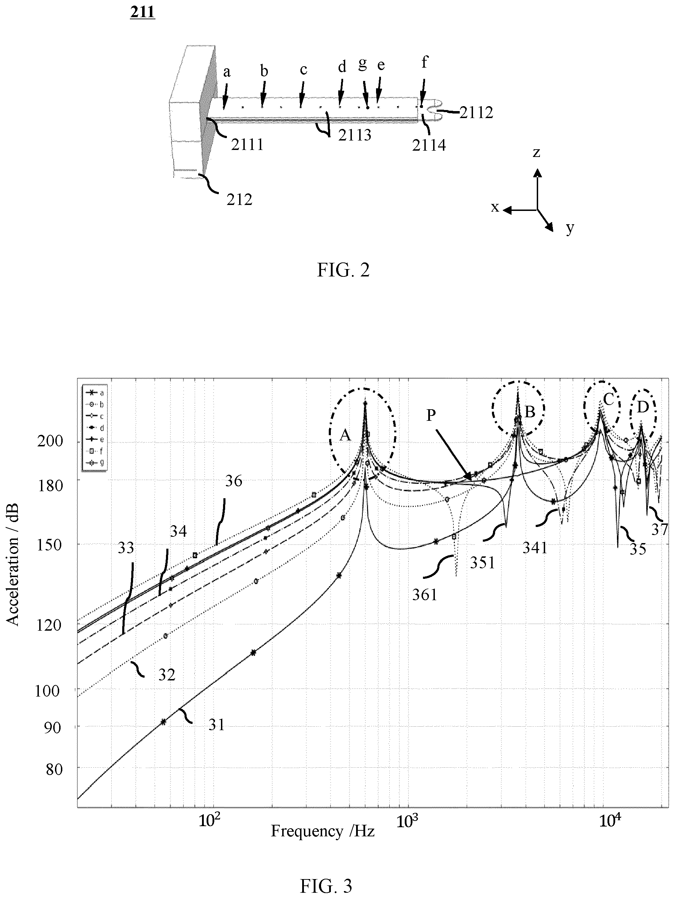

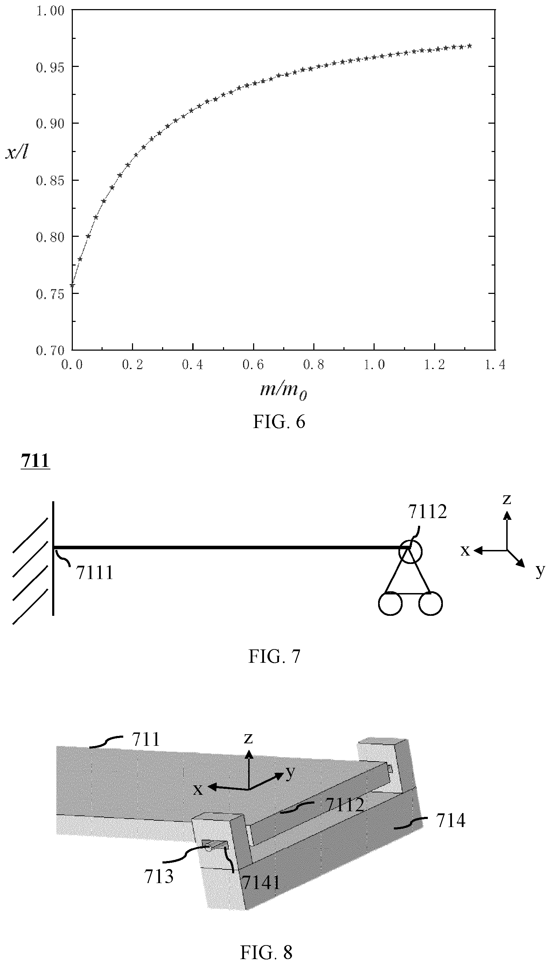

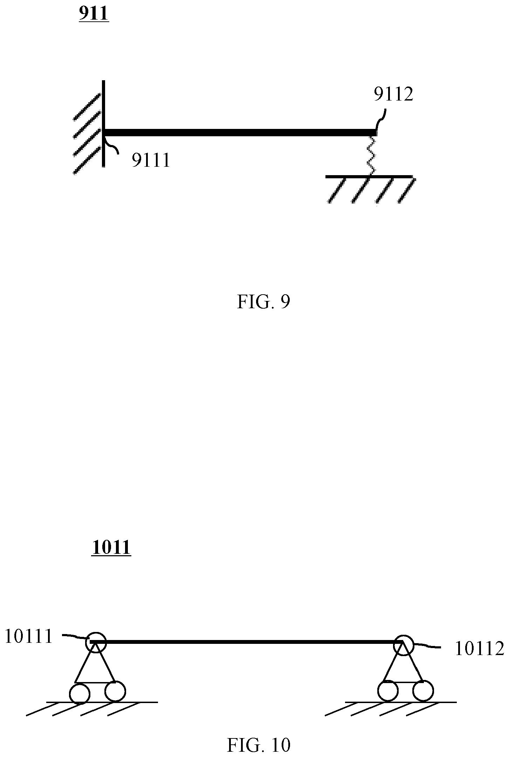

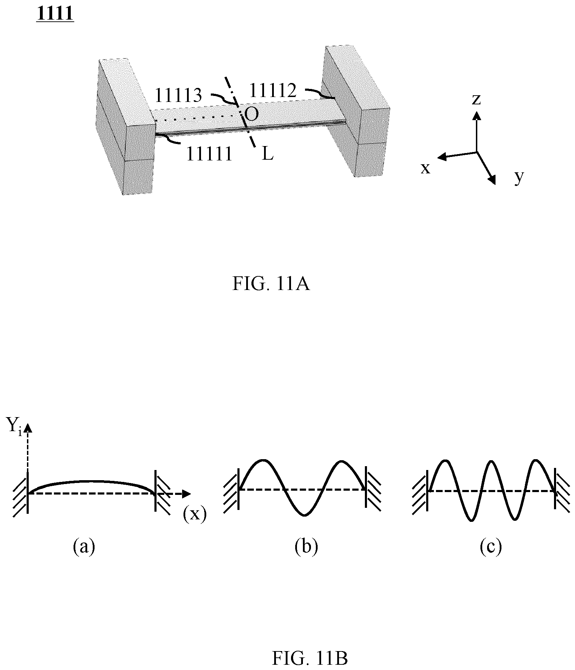

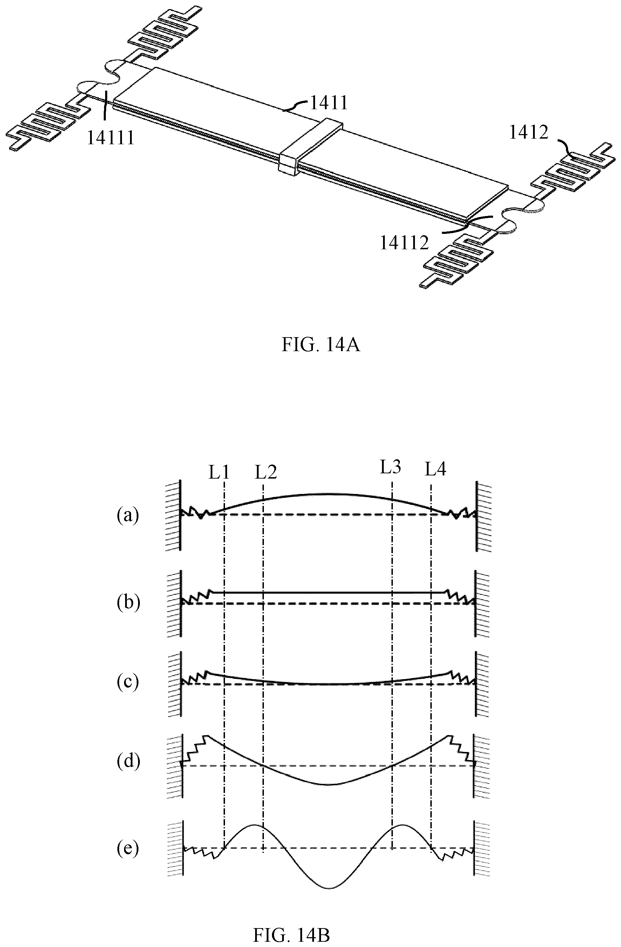

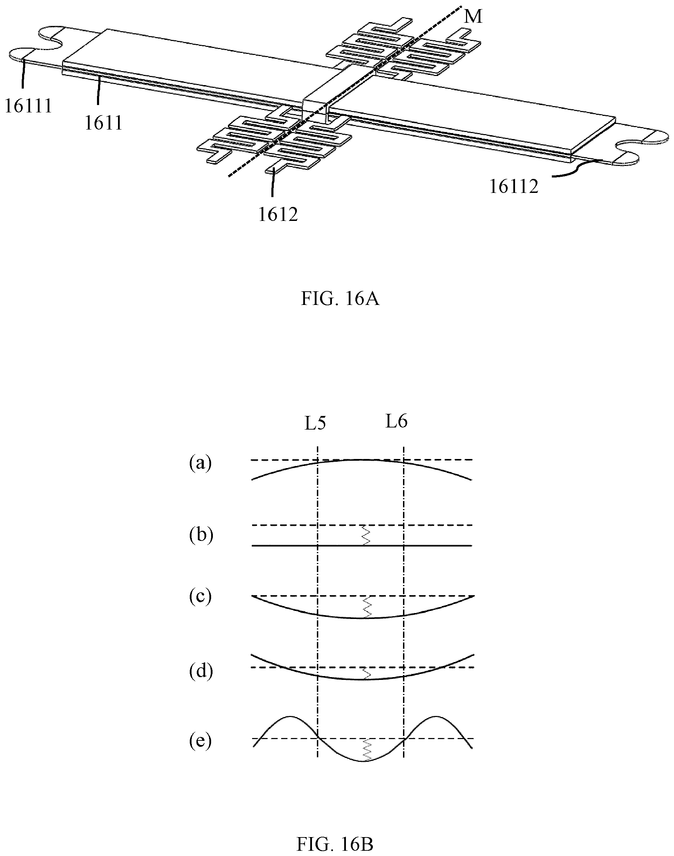

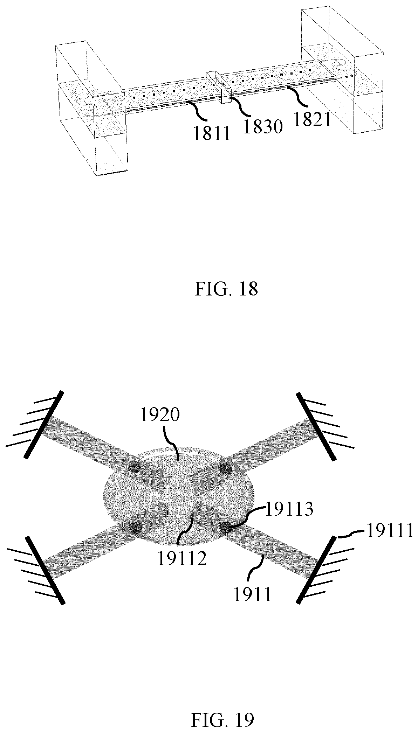

The vibration element 110 may be configured to convert an audio signal into a mechanical vibration. In some embodiments, the vibration element 110 may include a beam structure 111 extending along a length direction. In some embodiments, the beam structure 111 may be a cantilever beam fixed at one end (e.g., as shown in FIG. 2). In some embodiments, the beam structure 111 may be a beam with a fixed end and a hinged-support end (e.g., as shown in FIG. 7). In some embodiments, the beam structure 111 may be a beam with two hinged-support ends (e.g., as shown in FIG. 10). In some embodiments, the beam structure 111 may be a beam with two fixed ends (e.g., as shown in FIG. 11A). In some embodiments, the beam structure 111 may also be a beam with two elastic ends (e.g., as shown in FIG. 14A). In some embodiments, the beam structure 111 may also be a beam supported elastically in the middle (e.g., as shown in FIG. 16A). In some embodiments, a count of the vibration elements 110 may be two or more (e.g., as shown in FIG. 19).

In some embodiments, the vibration element 110 may also be a flake, a rod-like structure, etc. In some embodiments, a material of the vibration element 110 may be a material having the ability of transmitting vibrations. For example, the material of the vibration element 110 may include silicone, foam, plastic, rubber, metal, etc., or any combination thereof. In some embodiments, the vibration element 110 may be a component with good elasticity (i.e., prone to elastic deformation). For example, the vibration element 110 may include a spring (e.g., an air spring, a mechanical spring, an electromagnetic spring, etc.), a vibration transmitter, a shrapnel, a substrate, etc., or any combination thereof.

In some embodiments, the beam structure 111 may include a piezoelectric layer 1112. The piezoelectric layer 1112 may deform in response to an electrical signal (e.g., an electrical signal containing audio information), thereby driving the beam structure 111 to vibrate. For example, due to the inverse piezoelectric effect, the piezoelectric layer 1112 may deform in response to an electrical signal, and the deformation may drive the beam structure 111 (or the vibration element 110) to vibrate in a polarization direction of the piezoelectric layer 1112. In some embodiments, the vibration direction of the beam structure 111 may be perpendicular to the length direction of the beam structure 111 (i.e., a long axis direction of the beam structure 111). In some embodiments, the piezoelectric layer 1112 may include a material having a piezoelectric effect (or an inverse piezoelectric effect). Exemplary piezoelectric materials may include a piezoelectric ceramic, a piezoelectric crystal, a piezoelectric polymer (e.g., vinylidene fluoride), etc., or any combination thereof. In some embodiments, the piezoelectric layer 1112 may have any shape, such as a film, a flake, a block, a column, etc., or any combination thereof. In some embodiments, the piezoelectric layer 1112 may have a shape of a flake that is compatible with the shape of the beam structure 111. In some embodiments, the piezoelectric layer 1112 may be directly attached to the beam structure 111 by gluing or deposition. In some embodiments, the piezoelectric layer 1112 may be attached to the beam structure 111 via a snap connection, a buckle connection, etc. In some embodiments, the piezoelectric layer 1112 may be attached to the beam structure 111 by physical or chemical deposition. More description regarding the vibration element may be found elsewhere in the present disclosure. See, e.g., FIG. 2, FIG. 5, FIG. 7, etc., and relevant descriptions thereof.

The mass element 120 may be a component with a mass. In some embodiments, the mass element 120 may include a vibration plate, a diaphragm, etc., that enable the acoustic output apparatus 100 to output vibrations through the mass element 120. In some embodiments, the mass element 120 may have any shape, such as a cylinder, a rectangle, a cone, a dome, a sphere, and other regular or irregular shapes. In some embodiments, the material of the mass element 120 may include, but is not limited to, plastic, wood, metal, and other materials with a certain rigidity. In some embodiments, the material of the mass element 120 may also include various metamaterials such as a negative stiffness material, a cubic stiffness material, etc. that may facilitate the expansion of the audio bandwidth of the acoustic output apparatus 100. In some embodiments, the mass element 120 may be connected to a first position of the beam structure 111. The vibration of the first position on the beam structure 111 may drive the mass element 120 to generate a vibration in the same direction as the vibration element 110 (i.e., in a direction perpendicular to the length direction of the beam structure 111). The mass element 120 may be connected directly to the first position of the beam structure 111 or may be connected to the first position of the beam structure 111 through a connection rod (e.g., when the mass element 120 is a diaphragm, a center of the diaphragm may be connected to the first position of the beam structure 111 through a connection rod). For illustration purposes, the above-mentioned connection rod may also be considered as part of the mass element 120.

In some embodiments, a position of a resonance valley of a frequency response curve of the output device 100 may be adjusted by adjusting the first position on the beam structure 111 to which the mass element 120 is connected, without changing or substantially not changing the position of resonance peaks. In such cases, a frequency position corresponding to the resonance peak on the frequency response curve of the acoustic output apparatus 100 may be close to or the same as a frequency position corresponding to the resonance valley, which may reduce a range of unevenness on the frequency response curve caused by the resonance peak and the resonance valley, or may enable the resonance peak and the resonance valley to cancel each other when the frequency positions of the resonance peak and the resonance valley are the same and obtain a smooth curve in a wider frequency band, thereby improving the sound quality of the acoustic output apparatus. The resonant peak here may refer to a peak with a higher amplitude on the frequency response curve corresponding to the beam structure 111 (or the first position), and the resonant peak may be generated by a resonance of the beam structure near a resonance frequency thereof. In some embodiments, the beam structure 111 may have a plurality of resonance frequencies. Correspondingly, the frequency response curve may have a plurality of resonance peaks. The resonance valley may refer to a valley on the frequency response curve corresponding to the beam structure 111 (or the first position). Reasons for the formation of the resonance valley may include, but are not limited to, that the piezoelectric layer of the beam structure 111 generates split vibrations, which makes radiation sounds of the beam structure 111 at the first position cancel each other due to opposite phases, making it difficult to output the vibrations. In some embodiments, the piezoelectric layer may generate split vibrations near a plurality of frequencies. Correspondingly, the frequency response curve may have a plurality of resonance valleys. By adjusting the first position on the beam structure 111 to which the mass element 120 is connected, the resonance peak(s) and the resonance valley(s) on the frequency response curve of the acoustic output apparatus 100 may cancel each other such that a smooth curve in a wider frequency band may be obtained, which may improve the sound quality of the acoustic output apparatus. In some embodiments, a ratio between a distance from the first position to one end of the beam structure 111 and a length of the beam structure 111 may be in a range from 0.1 to 0.99. In some embodiments, the ratio between the distance from the first position to one end of the beam structure 111 and the length of the beam structure 111 may be in a range from 0.2 to 0.95. In some embodiments, the ratio between the distance from the first position to one end of the beam structure 111 and the length of the beam structure 111 may be in a range from 0.3 to 0.95. For example, the first position that makes a first-order resonance valley and a second-order resonance peak phase cancel each other may be determined such that when the frequency response curve of the acoustic output apparatus 100 includes a first resonance peak and a second resonance peak, a ratio of a frequency of the first resonance peak to a frequency of the second resonance peak may be greater than 17, and an amplitude difference between a minimum frequency response between the first resonance peak and the second resonance peak and the first resonance peak or the second resonance peak may be less than 40 dB. In such cases, the frequency response curve of the acoustic output apparatus 100 may be smooth in a wider frequency band at a lower frequency. As another example, the first position that makes the first-order resonance valley and a third-order resonance peak cancel each other may be determined such that the when frequency response curve of the acoustic output apparatus 100 includes a first resonance peak, a second resonance peak, and a third resonance peak, the first resonance peak may smoothly transition to the second resonance peak, the second resonance peak may smoothly transition to the third resonance peak, and a ratio of a frequency of the second resonance peak to a frequency of the third resonance peak may be greater than 4, such that the frequency response curve of the acoustic output apparatus 100 may be smooth in a wider frequency band at a higher frequency. More description regarding the determination of the first position may be found elsewhere in the present disclosure. See, e.g., FIG. 3, FIG. 7, FIG. 10-FIG. 16B, etc., and relevant descriptions thereof, which will not be repeated here. It should be noted that, for illustration purpose only, in the present disclosure, all the amplitude enhancements achieved when the frequency position of the resonance peak is close to or the same as the frequency position of the resonance valley may be referred to as peak and valley cancellation. Or in other words, the peak and valley cancellation described in the present disclosure may include that the resonance peak and resonance valley cancel each other when the frequency position of the resonance peak is the same as the frequency position of resonance valley, or may include that a range of unevenness on the frequency response curve caused by the resonance peak and the resonance valley is reduced, or an amplitude near the resonance peak is reduced and/or an amplitude near the resonance valley is increased when the frequency position of the resonance peak is close to the frequency position of resonance valley.

In some embodiments, the acoustic output apparatus 100 may also include a second vibration element. The second vibration element may include a second beam structure. The second beam structure may be connected to the beam structure 111. In some embodiments, a projection of a length direction of the second beam structure along the vibration direction of the vibration element 110 may be perpendicular to a projection of a length direction of the beam structure 111 along the vibration direction of the vibration element 110. More description regarding the acoustic output apparatus 100 including a second vibration element may be found elsewhere in the. See, e.g., FIG. 18 and/or FIG. 19 and relevant descriptions thereof, which will not be repeated here.

In some embodiments, the acoustic output apparatus 100 may also include a third vibration element. The third vibration element may include a third beam structure. The third beam structure may be flexibly connected to the beam structure 111 in a plane perpendicular to the vibration direction of the beam structure 111. In some embodiments, the third beam structure may extend along the length direction of the beam structure 111, one end of the beam structure 111 and one end of the third beam structure are fixed ends, and the other end of the beam structure 111 may be connected to the other end of the third beam structure through an elastic connection member. More description regarding the third vibration element may be found elsewhere in the. See, e.g., FIG. 19 and relevant descriptions thereof, which will not be repeated here.

It is to be noted that the above description of FIG. 1 is provided for illustrative purposes only and is not intended to limit the scope of the present disclosure. For those skilled in the art, a plurality of variations and modifications may be made under the teachings of the present disclosure. For example, in some embodiments, the acoustic output apparatus 100 may also include one or more components (e.g., a signal transceiver, an interaction module, a battery, etc.). In some embodiments, one or more components of the acoustic output apparatus 100 may be replaced by other elements capable of performing similar functions. However, those variations and modifications do not depart from the scope of the present disclosure.

FIG. 2 is a schematic diagram illustrating an exemplary beam structure according to some embodiments of the present disclosure. As shown in FIG. 2, the beam structure 211 may be a cantilever beam. One end of the beam structure 211 may be a fixed end 2111 and the other end departing from the fixed end 2111 in the length direction (i.e., the x-direction shown in FIG. 2) may be a free end 2112.

The fixed end 2111 may be a position on the beam structure 211 in the operating state where a vibration acceleration or acceleration level is less than a vibration acceleration threshold or an acceleration level threshold and a rotation angle of a cross section of the beam structure 211 at the position is less than a rotation angle threshold. Merely by way of example, the vibration acceleration level of the fixed end 2111 may be less than 5 dB, 3 dB, 1 dB, 0.8 dB, 0.6 dB, 0.4 dB, 0.2 dB, 0.05 dB, etc., and the rotation angle of the cross section may be less than 3°, 2°, 1°, 0.5°, 0.2°, 0.05°, etc. In some embodiments, the fixed end 2111 may be connected to a fixed position or structure (e.g., a housing) of the acoustic output apparatus. The fixed position or structure here may be a position or a structure on the acoustic output apparatus where a vibration acceleration or an acceleration level is less than a vibration acceleration threshold or an acceleration level threshold. In some embodiments, the fixed end 2111 may be fixed to a fixed support 212. The fixed support 212 may be connected to a fixed position or structure of the acoustic output apparatus. For example, the acoustic output apparatus may include a housing (not shown in FIG. 2), the beam structure 211 may be disposed in the housing, a fixed support 212 may be fixed to the housing, and the fixed end 2111 of the beam structure 211 may be fixedly connected to the fixed support 212 on the housing. The free end 2112 may be an end of the beam structure 211 that is free to vibrate. In some embodiments, the free end 2112 may be in an overhanging or unconstrained state.

In some embodiments, the beam structure 211 may include a piezoelectric layer 2113 and a substrate layer 2114. In some embodiments, the piezoelectric layer 2113 and the substrate layer 2114 may extend along the length direction of the beam structure 211. When the vibration element is subjected to an electric field in its thickness direction (i.e., a z-direction shown in FIG. 2), the piezoelectric layer 2113 may be deformed along a length direction thereof. The deformation may drive the substrate layer 2114 (or the vibration element) to generate vibrations along a direction perpendicular to the length direction of the beam structure 211. In some embodiments, the piezoelectric layer 2113 may be made of a piezoelectric material. In some embodiments, a material of the substrate layer 2114 may include, but is not limited to, a metal, an alloy, a glass fiber, a carbon fiber, etc., or any combination thereof. In some embodiments, the piezoelectric layer 2113 and the substrate layer 2114 may be disposed overlapping in the thickness direction of the beam structure 211. In some embodiments, the beam structure 211 may include a plurality of piezoelectric layers 2113 and substrate layers 2114. The plurality of piezoelectric layers 2113 and substrate layers 2114 may be disposed overlapping in the thickness direction.

A mass element may be connected to the first position of the beam structure 211. In some embodiments, the first position of the beam structure 211 may be different positions along the length direction on the beam structure 211, for example, point a, point b, point, point c, point d, point e, point f, point g, etc. as illustrated in FIG. 2. In some embodiments, vibration modes at different first positions on the beam structure 211 may be different. Correspondingly, the vibration modes output to the mass elements connected at the first positions may be different, and the frequency response curves of the acoustic output apparatus may be different. More description may be found elsewhere in the present disclosure. See, e.g., FIG. 3 and relevant descriptions thereof.

FIG. 3 is a graph illustrating vibration response curves of a beam structure at different points according to some embodiments of the present disclosure. As shown in FIG. 3, curve 31, curve 32, curve 33, curve 34, curve 35, curve 36, and curve 37 are the frequency response curves of point a, point b, point c, point d, point e, point f, and point g on the beam structure 211 (i.e., cantilever beam) shown in FIG. 2 when vibration occurs. In some embodiments, the mass element may have a small or zero effect on the vibration of the beam structure 211, the curves 31-37 may also be used to denote the frequency response curves of the acoustic output apparatus (e.g., the acoustic output apparatus 100) when the mass element is connected in each of the seven first positions described above.

According to FIG. 3, in a range of 50 Hz to 10,000 Hz, the vibrations at different first positions on the beam structure 211 may generate a plurality of resonance peaks (e.g., a first-order resonance peak A, a second-order resonance peak B, a third-order resonance peak C, etc.). The positions of the resonance peaks generated at different first positions may be approximately the same. As the first position gradually approaches the fixed end 2111 of the beam structure 211, the resonance valley of the corresponding frequency response curve may gradually move to higher frequencies. merely by way of example, according to curve 34, curve 35, and curve 36, as the first position gradually moves from point f to point d toward the fixed end 2111, the first-order resonance valley 361 corresponding to point f, the first-order resonance valley 351 corresponding to point e, and the first-order resonance valley 341 corresponding to point d may gradually move toward higher frequencies. Further according to curves 31-33 corresponding to points a-c, as the first position gradually approaches the fixed end 2111 of the beam structure 211, the frequency response curves of the acoustic output apparatus may be smoother between the first-order resonance peaks A and the second-order resonance peaks B and/or between the second-order resonance peaks B and the third-order resonance peaks C, which may be specifically shown as: the first-order resonance peak A smoothly transitions to the second-order resonance peak B and/or the second-order resonance peak B smoothly transitions to the third-order resonance peak C, there is no resonance valley with low amplitude, and the curve between the two resonance peaks has a "U" shape. For example, curve 34 corresponding to point d has a smooth transition between the first-order resonance peak A and the second-order resonance peak B. As another example, curve 33 corresponding to point c has a smooth transition between the first-order resonance peak A and the second-order resonance peak B, and a smooth transition between the second-order resonance peak B and the third-order resonance peak C. Moreover, further according to curves 31-36, the amplitude of the acoustic output apparatus at low and medium frequencies (e.g., 50 Hz-500 Hz in FIG. 3) may gradually decrease as the first position gradually approaches the fixed end 2111 of the beam structure 211, which may reduce the sensitivity of the acoustic output apparatus at low and medium frequencies. In such cases, a suitable first position may be determined such that the frequency response curve of the acoustic output apparatus in the audible domain of the human ear (e.g., 50 Hz-10,000 Hz) may transition smoothly among the resonance peaks without unduly reducing the sensitivity of the acoustic output apparatus in the low and mid frequencies. In some embodiments, the position near point c may be determined as the first position, thus which may improve the sound quality of the acoustic output apparatus and make the acoustic output apparatus have a high sensitivity in the low and mid frequencies. In some embodiments, a ratio between the distance from the first position near point c to the fixed end 2111 and the length of the beam structure 211 may be in a range from 0.45 to 0.55.

Further, according to curve 37 corresponding to point g, curve 37 has a smooth transition in the range of 500 Hz-10,000 Hz, which may be specifically shown as: there is a small or no resonance peak and/or resonance valley between the first-order resonance peak A and the third-order resonance peak C, and the amplitude difference between the minimum frequency response between the first-order resonance peak A and the third-order resonance peak C (e.g., point P shown in FIG. 3) and the first resonance peak or the second resonance peak may be less than 40 dB. This is because the first-order resonance valley cancels the second-order resonance peak corresponding to curve 37 such that curve 37 has no resonance peak and/or resonance valley near the frequency corresponding to the second-order resonance peak B. In such cases, a suitable first position (e.g., point g) may be determined such that the first-order resonance valley of the acoustic output apparatus may cancel the second-order resonance peak. In such cases, the frequency response curve may include a first resonance peak (i.e., the first-order resonance peak A) and a second resonance peak (i.e., the third-order resonance peak C) in part of the audible domain of the human ear (e.g., 50 Hz-10,000 Hz), and a ratio of a frequency of the second resonance peak to a frequency of the first resonance peak may be greater than 17, which may increase the frequency range corresponding to the smooth curve on curve 37, thereby further improving the sound quality of the acoustic output apparatus. In some embodiments, a ratio between the distance from the point g to the fixed end 2111 and the length of the beam structure 211 may be in a range from 0.75 to 0.95. In some embodiments, the ratio between the distance from the point g to the fixed end 2111 and the length of the beam structure 211 may be in a range from 0.78 to 0.85. In some embodiments, the ratio between the distance from the point g to the fixed end 2111 and the length of the beam structure 211 may be 0.81.

According to FIG. 3 and the description thereof, a suitable first position may be determined such that the peak and valley cancellation may be achieved on the frequency response curve of the acoustic output apparatus in a specific frequency range (e.g., 500 Hz-10,000 Hz), which may eliminate resonance valleys with poor frequency response in the specific frequency range and increase the frequency range corresponding to the smooth curve on the frequency response curve of the acoustic output apparatus, thereby improving the sound quality of the acoustic output apparatus. In some embodiments, the first position (or the ratio between the first position and the length of the beam structure) may be determined based on calculations such that the peak and valley cancellation may be achieved on the frequency response curve of the acoustic output apparatus at the first position. In some embodiments, displacements of points at various positions on the beam structure may be expressed as:

$$u(x,t) = Y(x) * \phi(t), \qquad (1)$$

where $Y(x)$ denotes a vibration function, $\phi(t)$ denotes a harmonic function with respect to time, $x$ denotes a distance from a position point on the beam structure to one end of the beam structure (e.g., the fixed end 2111 of the beam structure 211), and $u(x, t)$ satisfies a differential equation of motion:

$$EI \frac{\partial^4 u(x,t)}{\partial x^4} + \rho A \frac{\partial^2 u(x,t)}{\partial t^2} = F, \qquad (2)$$

where $E$ denotes an elastic modulus of the beam structure, $I$ denotes a moment of inertia of a cross-section of the beam structure, $\rho$ denotes a material density of the beam structure, $A$ denotes a cross-sectional area of the beam structure, and $F$ denotes an external force applied to the beam structure. Let the external force $F = 0$ and separate variables, the intrinsic vibration function $Y(x)$ of the beam structure may be expressed as:

$$Y(x) = C_1 sin\beta x + C_2 cos\beta x + C_3 sh\beta x + C_4 ch\beta x, \\ \phi(t) = C_5 sinwt + C_6 coswt \qquad , \qquad (3)$$

where, $C_1$-$C_6$ are constants, and $\beta^4 = \frac{\rho A}{EI} w^2$ , $w$ denotes the circle frequency.

According to equation (3), different boundary conditions for different beam structures can be substituted such that the inherent vibration functions corresponding to different beam structures may be determined. For example, for the beam structure 211 shown in Fig. 2, both a displacement and a rotation angle (proportional to a first-order derivative of the displacement) of the fixed end may be zero, and a bending moment and a shear force (proportional to second-order and third-order derivatives of displacement, respectively) of the free end may be zero. The boundary condition of the beam structure 211 may be: $Y(0) = Y'(0) = Y''(l) = Y'''(l) = 0$. By substituting the boundary condition into equation (3), the intrinsic vibration function of the beam structure 211 (i.e., the cantilever beam) may be obtained and expressed as:

$$Y_i(x) = ch(\beta_i x) - cos(\beta_i x) - \frac{ch(\beta_i l) + cos(\beta_i l)}{sh(\beta_i l) + sin(\beta_i l)} [sh(\beta_i x) - sin(\beta_i x)], \qquad (4)$$

where $i$ denotes an order corresponding to the intrinsic vibration, $\beta_i$ satisfies $ch(\beta_i l)$. $cos(\beta_i l) + 1 = 0$, $\beta_1 l$ = 1.875, $\beta_2 l$ = 4.694, $\beta_3 l$ = 7.855 .......

According to FIG. 3 and the description thereof, a position of the resonance peak of the acoustic output apparatus may be relatively fixed when different first positions are determined. As the first position gradually approaches the fixed end of the beam structure, the resonance valley may gradually move toward higher frequencies and may cancel the resonance peak when the resonance valley moves to a frequency position that is the same as or similar to a frequency position of the resonance peak. In such cases, a vibration node of the intrinsic vibration function of the beam structure at the resonance peak may be the first position that makes the frequency response curve of the beam structure achieve the peak and valley cancellation. For the beam structure 211, if $Y_i(x)=0$ in equation (4), a solution may correspond to the first position that makes the peak and valley cancellation occurs at the $i$-order ($i=1, 2, 3......$) resonance peak.

Merely by way of example, according to equation (4), a solution $x$ obtained when $Y_2(x)=0$ may be the distance from the first position that makes the first-order resonance valley and the second-order resonance peak cancel each other on the beam structure 211 to the fixed end 2111 of the beam structure 211, and a ratio between the distance from the first position to the fixed end 2111 of the beam structure 211 and the length of the beam structure 211 may be about 0.774. Similarly, a ratio between the distance from the first position to the fixed end 2111 of the beam structure 211 and the length of the beam structure 211 may be approximately 0.501 such that the first-order resonance valley and the third-order resonance peak of the beam structure 211 may cancel each other. A ratio between the distance from the first position to the fixed end 2111 of the beam structure 211 and the length of the beam structure 211 may be about 0.868 such that the second-order resonance valley and the third-order resonance peak of the beam structure 211 may cancel each other.

In some embodiments, the first position that makes the first-order resonance valley and the second-order resonance peak cancel each other may be determined as a vibration output position of the acoustic output apparatus, such that the acoustic output apparatus may achieve peak and valley cancellation in a specific frequency range (e.g., 500 Hz - 10,000 Hz). Correspondingly, the acoustic output apparatus may have a first resonance peak (e.g., the first-order resonance peak A) and a second resonance peak (e.g., the third-order resonance peak C) in part of the audible domain of the human ear (e.g., 50 Hz-10,000 Hz) and a smoother curve between the first resonance peak and the second resonance peak may be obtained, which may improve the sound quality of the acoustic output apparatus in the specific frequency range. Based on the above theoretical solution and considering the error of practical application, in some embodiments, to make the first-order resonance valley and the second-order resonance peak of the beam structure 211 cancel each other such that the acoustic output apparatus may have a smooth curve between the first resonance peak and the second resonance peak in a wide frequency band, the ratio between the distance from the first position to the fixed end 2111 and the length of the beam structure 211 may be in a range from 0.75 to 0.95 within. In some embodiments, the ratio between the distance from the first position to the fixed end 2111 and the length of the beam structure 211 may be in a range from 0.75 to 0.9. In some embodiments, the ratio between the distance from the first position to the fixed end 2111 and the length of the beam structure 211 may be in a range from 0.75 to 0.86. In some embodiments, the ratio between the distance from the first position to the fixed end 2111 and the length of the beam structure 211 may be in a range from 0.77 to 0.84.

In some embodiments, the first position that makes the first-order resonance valley and the third-order resonance peak cancel each other may also be determined as the vibration output position of the acoustic output apparatus such that the acoustic output apparatus may achieve peak and valley cancellation in a specific frequency range (e.g., 2000 Hz - 20,000 Hz). Correspondingly, the acoustic output apparatus may have a first resonance peak (e.g., the first-order resonance peak A), a second resonance peak (e.g., the second-order resonance peak B), and a third resonance peak (e.g., the fourth-order resonance peak D) in part of the audible domain of the human ear (e.g., 50 Hz-15000 Hz). An amplitude difference between the minimum frequency response between the second resonance peak and third resonance peak and the second resonance peak or the third resonance peak may be less than 30 dB, and a ratio between a frequency of the third and a frequency of the second resonance peak may be greater than 4. A smooth curve in a wide frequency band may be obtained between the second resonance peak and third resonance peak, which may improve the sound quality of the acoustic output apparatus in the specific frequency range (e.g., 2000 Hz-15000 Hz). In addition, the sound quality of the acoustic output apparatus in the lower frequency range (e.g., 500 Hz-2000 Hz) may be further improved due to the smooth transition between the first resonance peak and the second resonance peak as the first-order resonance valleys move to higher frequencies. In some embodiments, the ratio between the distance from the first position to the fixed end 2111 and the length of the beam structure 211 may be in a range from 0.45 to 0.6 such that the first-order resonance valley and the third-order resonance peak of the beam structure 211 may cancel each other, thereby improving the sound quality of the acoustic output apparatus. In some embodiments, the ratio between the distance from the first position to the fixed end 2111 and the length of the beam structure 211 may be in a range from 0.47 to 0.55. In some embodiments, the ratio between the distance from the first position to the fixed end 2111 and the length of the beam structure 211 may be in a range from 0.49 to 0.51.

It should be noted that the first position and the range thereof are described for illustration purposes only and are not intended to limit the scope of the present disclosure. In some embodiments, different first positions may also be determined such that resonance peaks and resonance valleys of different orders may cancel each other (e.g., a first-order resonance valley and a third-order resonance peak may cancel each other, a second-order resonance valley and a third-order resonance peak may cancel each other, etc.). In such cases, the acoustic output apparatus may have a smooth curve in a wider frequency band at different frequencies to satisfy the needs of different scenarios.

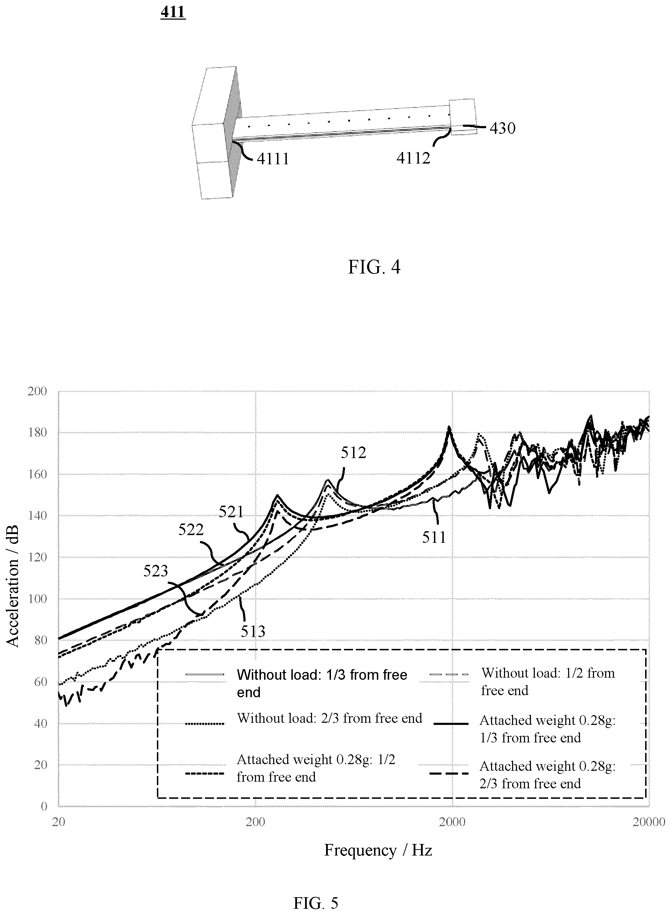

FIG. 4 is a schematic diagram illustrating an exemplary structure of a beam structure according to some embodiments of the present disclosure. The beam structure 411 shown in FIG. 4 may be substantially the same as the beam structure 211 shown in FIG. 2. A difference between the beam structure 411 and the beam structure 211 may include that the beam structure 411 shown in FIG. 4 may also include a second mass element 430. As shown in FIG. 4, the beam structure 411 may include a fixed end 4111 and a free end 4112. The second mass element 430 may be connected to the free end 4112. In some embodiments, the second mass element 430 may be similar to the mass element. In some embodiments, the second mass element 430 may be an additional mass introduced by the beam structure 411 during assembly, etc. In some embodiments, a ratio between the mass of the second mass element 430 and the mass of the beam structure 411 may be in a range from 0 to 1.2so as to prevent vibration modes of the beam structure 411 from being affected by the excessive mass of the second mass element 430.

When the second mass element 430 is connected to the beam structure 411, the vibration mode at the first position may be different from the vibration mode at the same first position when the beam structure 211 is not connected to the second mass element 430. More descriptions may be found in FIG. 5.

FIG. 5 is a graph illustrating vibration response curves of a beam structure at different points along a length direction of the beam structure when the beam structure is with or without a load according to some embodiments of the present disclosure. The beam structure being without a load refers to that there is no additional mass on the beam structure (or cantilever beam) (e.g., the beam structure 211 without the second mass element 430). The beam structure being with a load refers to that a second mass element 430 is connected to the beam structure 411. Merely by way of example, the frequency response curves shown in FIG. 5 correspond to a second mass element 430 of 0.28 g. As shown in FIG. 5, curve 511, curve 512, and curve 513 the frequency response curves at 1/3 (i.e., a distance from the first position to the free end is 1/3 of the length of the beam structure), 1/2, and 2/3, respectively of the beam structure from the free end when the beam structure is without a load. Curve 521, curve 522, and curve 523 are the frequency response curves at 1/3, 1/2, and 2/3, respectively, of the beam structure from the free end when the beam structure is with a load. Shapes of the curves 511, 512, and 513 of the beam structure when the beam structure is without a load may be approximately the same as shapes of the curves 521, 522, and 523 of the beam structure when the beam structure is with a load. Resonance peaks of the beam structure when the beam structure is with a load may move to lower frequencies compared to the resonance peaks of the beam structure when the beam structure is without a load. Thus, the second mass element may affect a ratio between a distance from the first position to the fixed end between the length of the beam structure, wherein the first position may make the frequency response curve of the beam structure achieve the peak and valley cancellation. More descriptions may be found in FIG. 6.

FIG. 6 is a graph illustrating a relationship between a ratio of a mass of a second mass element to a beam structure and a ratio of a distance from a first position to a fixed end to a length of the beam structure according to some embodiments of the present disclosure. The first position may be a first position that makes the frequency response curve of the beam structure achieve the peak and valley (e.g., a first-order resonance valley and a second-order resonance peak) cancellation. As shown in the curve in FIG. 6, the horizontal coordinate $m/m_0$ denotes the ratio between the mass m of the second mass element and the mass $m_0$ of the beam structure, and the vertical coordinate $x/l$ denotes the ratio between the distance from the first position to the fixed end and the length of the beam structure. According to FIG. 6, the ratio between the distance from the first position to the fixed end and the length of the beam structure may gradually increase as the ratio of the mass of the second mass element to the beam structure increases. In such cases, the first position may be determined based on the ratio between the mass of the second mass element and the mass of the beam structure such that the frequency response curve of the acoustic output apparatus may achieve a peak and valley cancellation in the audible domain of the human ear. For example, the ratio between the mass of the second mass element and the mass of the beam structure may be in a range from 0 to 1.2, and the ratio between the distance from the first position to the fixed end and the length of the beam structure (or the cantilever beam) may be in a range from 0.75 to 0.95. As another example, the ratio between the mass of the second mass element and the mass of the beam structure may be in a range from 0 to 0.5, and the ratio between the distance from the first position to the fixed end and the length of the beam structure (or the cantilever beam) may be in a range from 0.75 to 0.92. As another example, the ratio between the mass of the second mass element and the mass of the beam structure may be in a range from 0.2 to 1, and the ratio between the distance from the first position to the fixed end and the length of the beam structure (or the cantilever beam) may be in a range from 0.8 to 0.95.

FIG. 7 is a schematic diagram illustrating an exemplary structure of a beam structure according to some embodiments of the present disclosure. The beam structure 711 shown in FIG. 7 may be substantially the same as the beam structure 211 shown in FIG. 2. A difference between the beam structure 711 and the beam structure 211 may include that the beam structure 711 shown in FIG. 7 includes a hinged-support end 7112. As shown in FIG. 7, the beam structure 711 may include a fixed end 7111 and a hinged-support end 7112. The fixed end 7111 and the hinged-support end 7112 may be two ends of the beam structure 711 that are away from each other along the length direction (e.g., the x-direction shown in FIG. 7). The fixed end 7111 may be similar to the fixed end 2111.

The hinged-support end 7112 may be a rotatable end. In some embodiments, the hinged-support end 7112 may include an axis (e.g., an axis parallel to the y-direction shown in FIG. 7) that is perpendicular to the length direction and vibration direction (e.g., the z-direction shown in FIG. 7) of the beam structure 711. The hinged-support end 7112 may rotate about the axis. FIG. 8 is a schematic diagram illustrating an exemplary structure of a hinged-support end according to some embodiments of the present disclosure. In some embodiments, as shown in FIG. 8, the hinged-support end 7112 may be connected relatively fixedly to a hinged rod 713 on both sides along a length direction (i.e., the y-direction) of the hinged-support end 7112. An axis in which the hinged rod 713 is located (the y-direction shown in FIG. 8) may be perpendicular to the length direction (the x-direction shown in FIG. 8) and vibration direction (the z-direction shown in FIG. 8) of the beam structure 711. The beam structure 711 (or the acoustic output apparatus) may also include a hinged-support base 714. The hinged-support base 714 may be fixed in the acoustic output apparatus (e.g., on the housing) and may include a hinged hole 7141. The hinged rod 713 may be disposed in the hinged hole 7141 and may rotate within the hinged hole 7141. When the beam structure 711 vibrates in its vibration direction, the hinged-support end 7112 may rotate relative to the hinged-support base 714 along the axis where the hinged rod 713 is located. In some embodiments, the hinged rod 713 may be physically connected to the hinged-support end 7112. In some embodiments, the hinged rod 713 and the hinged-support end 7112 may be integrated.

In some embodiments, similar to the cantilever beams described in the present disclosure (e.g., the beam structure 211, the beam structure 411, etc.), for the beam structure 711 as shown in FIG. 7, a first position may be determined such that the frequency response curve of the acoustic output apparatus may achieve the peak and valley cancellation, which may increase the range of the smooth curve of the frequency response curve of the acoustic output apparatus in the audible domain of the human ear, thereby improving the sound quality of the acoustic output apparatus. In some embodiments, the intrinsic vibration function $Y_i(x)$ of the beam structure 711 including the fixed end 7111 and the hinged-support end 7112 may be similar to the intrinsic vibration function of the beam structure 211 (i.e., equation (4)). For the intrinsic vibration function of the beam structure 711, $\beta_i$ satisfies $ch(\beta_i l) * sin(\beta_i l) - cos(\beta_i l) * sh(\beta_i l) = 0$. Then the $\beta_i l$ values corresponding to each order may be obtained. The $\beta_i l$ values may be substituted into equation (4), and a solution of equation (4) when $Y_i(x)=0$ may be the distance from the first position that makes the peak and valley cancellation occurs at the $i$-order ($i=1, 2, 3......$) resonance peak to the fixed end 7111 of the beam structure 711.

Merely way of example, according to equation (4), the solution obtained when $Y_2(x)=0$ may be the distance from the first position that makes the first-order resonance valley and the second-order resonance peak of the beam structure 711 cancel each other to the fixed end 7111 of the beam structure 711. A ratio between the first position to the fixed end 7111 of the beam structure 711 and the length of the beam structure 711 may be about 0.56. Similarly, a ratio between the distance from the first position to the fixed end 7111 of the beam structure 711 and the length of the beam structure 711 may be about 0.39 or 0.69 such that the first-order resonance valley and the third-order resonance peak of the beam structure 711 may cancel each other.

In some embodiments, the first position that makes the first-order resonance valley and the second-order resonance peak cancel each other may be determined as the vibration output position on the beam structure 711 such that the acoustic output apparatus may have a first resonance peak (e.g., the first-order resonance peak A as shown in FIG. 3) and a second resonance peak (e.g., the third-order resonance peak C as shown in FIG. 3) in part of the audible domain of the human ear (e.g., 50 Hz-10,000 Hz) and a smoother curve between the first resonance peak and the second resonance peak may be obtained, which may improve the sound quality of the acoustic output apparatus in the specific frequency range. According to the theoretical solution and considering the error of practical application, in some embodiments, make the first-order resonance valley and the second-order resonance peak of the beam structure 711 cancel each other, wherein a ratio of the frequency of the second resonance peak to the frequency of the first resonance peak may be greater than 6, such that the acoustic output apparatus may have a smooth curve between the first resonance peak and the second resonance peak, the ratio between the distance from the first position to the fixed end 7111 and the length of the beam structure 711 may be in a range from 0.5 to 0.6. In some embodiments, the ratio between the distance from the first position to the fixed end 7111 and the length of the beam structure 711 may be in a range from 0.52 to 0.59. In some embodiments, the ratio between the distance from the first position to the fixed end 7111 and the length of the beam structure 711 may be in a range from 0.54 to 0.58.

In some embodiments, the first position that makes the first-order resonance valley and the third-order resonance peak cancel each other may also be determined as the vibration output position on the beam structure 711 such that the acoustic output apparatus may achieve peak and valley cancellation. Correspondingly, the acoustic output apparatus may have a first resonance peak (e.g., the first-order resonance peak A as shown in FIG. 3), a second resonance peak (e.g., the second-order resonance peak B as shown in FIG. 3), and a third resonance peak (e.g., the fourth-order resonance peak D as shown in FIG. 3) in part of the audible domain of the human ear (e.g., 50 Hz-15000 Hz). At this time, as the first-order resonance valleys move to higher frequencies, the first resonance peak may smoothly transition to the second resonance peak, the second resonance peak may smoothly transition to the third resonance peak, and a smooth curve in a wider frequency range may be obtained, which may improve the sound quality of the acoustic output apparatus. In some embodiments, to make the first-order resonance valley and the third-order resonance peak of the beam structure 711 cancel each other, thereby improving the sound quality of the acoustic output apparatus, the ratio between the distance from the first position to the fixed end 7111 and the length of the beam structure 711 may be in a range from 0.35 to 0.45. In some embodiments, the ratio between the distance from the first position to the fixed end 7111 and the length of the beam structure 711 may be in a range from 0.36 to 0.43. In some embodiments, the ratio between the distance from the first position to the fixed end 7111 and the length of the beam structure 711 may be in a range from 0.37 to 0.41. In some embodiments, to make the first-order resonance valley and the third-order resonance peak of the beam structure 711 cancel each other, thereby improving the sound quality of the acoustic output apparatus, the ratio between the distance from the first position to the fixed end 7111 and the length of the beam structure 711 may also be in a range from 0.65 to 0.75 In some embodiments, the ratio between the distance from the first position to the fixed end 7111 and the length of the beam structure 711 may be in a range from 0.67 to 0.72. In some embodiments, the ratio between the distance from the first position to the fixed end 7111 and the length of the beam structure 711 may be in a range from 0.68 to 0.7.

FIG. 9 is a schematic diagram illustrating an exemplary structure of a beam structure according to some embodiments of the present disclosure. The beam structure 911 shown in FIG. 9 may be substantially the same as the beam structure 711 shown in FIG 7. A difference between the beam structure 911 and the beam structure 711 may include that the beam structure 911 shown in FIG. 9 includes an elastic end 9112. As shown in FIG. 9, the beam structure 911 may include a fixed end 9111 and an elastic end 9112. The fixed end 9111 and the elastic end 9112 may be two ends of the beam structure 911 that are away from each other. The fixed end 9111 may be similar to the fixed end 7111. The elastic end 9112 may be an end of the beam structure 911 that is elastically connected to other components of the acoustic output apparatus (e.g., the housing). In some embodiments, the intrinsic vibration function of the beam structure 911 obtained after substituting the boundary conditions may be similar to the intrinsic vibration function of the beam structure 211 (i.e., equation (4)). For the intrinsic vibration function of the beam structure 911, $\beta_i$ satisfies:

$$-\beta_i{}^3 \frac{cos(\beta_i l)*ch(\beta_i l)+1}{ch(\beta_i l)*sin(\beta_i l)-cos(\beta_i l)*sh(\beta_i l)} = \frac{k}{EI}$$ , where $k$ denotes an elastic coefficient corresponding to the elastic connection of the elastic end 9112. Accordingly, the $\beta_i$ value of each order may be obtained and substituted into equation (4), and a solution of equation (4) when $Y_i(x)=0$ may be the distance from the first position that makes the peak and valley cancellation occurs at the $i$-order ($i=1, 2, 3......$) resonance peak to the fixed end 9111 of the beam structure 911. Optionally or additionally, the beam structure 211 (i.e., the free beam) may be equivalent to the beam structure 911 when the elastic coefficient $k$ corresponding to the elastic end 9112 is 0. The beam structure 711 may be equivalent to the beam structure 911 when the elastic coefficient $k$ corresponding to the elastic end 9112 is ∞.

FIG. 10 is a schematic diagram illustrating an exemplary beam structure according to some embodiments of the present disclosure. The beam structure 1011 shown in FIG. 10 may be substantially the same as the beam structure 711 shown in FIG. 7. A difference between the beam structure 1011 and the beam structure 711 may include that the beam structure 1011 shown in FIG. 10 includes two hinged-support ends 10111 and 10112, respectively. As shown in FIG. 10, the two hinged-support ends 10111 and 10112 may be two ends of the beam structure 1011 that are away from each other. The hinged-support ends 10111 and 10112 may be similar to the hinged-support end 7112.

In some embodiments, for the beam structure 1011 as shown in FIG. 10, the first position may be determined such that the frequency response curve of the acoustic output apparatus may achieve a peak and valley cancellation, which may increase the range of the smooth curve of the frequency response curve of the acoustic output apparatus in the audible domain of the human ear, thereby improving the sound quality of the acoustic output apparatus. In some embodiments, the intrinsic vibration function of the beam structure 1011 obtained after substitution of the boundary conditions may be expressed as:

$$Y_i(x) = \sin(\beta_i x), \qquad (5)$$

where $\beta_i$ satisfies: $sin(\beta_i l) = 0$, the $\beta_i l$ value of each order may be obtained. After substituting the $\beta_i l$ value into equation (5), a solution of equation (5) when $Y_i(x)=0$ may correspond to the first position that makes the peak and valley cancellation occurs at the $i$-order (i=1, 2, 3 ......) resonance peak.

Merely by way of example, according to Equation (5), in some embodiments, the beam structure 1011 may be a symmetrical structure at both ends (i.e., the hinged-support ends 10111 and 10112). When the beam structure 1011 is driven by piezoelectricity, even-order resonance modes of the beam structure 1011 may disappear, leaving only odd-order resonance peaks. The ratio between the distance from the first position to the hinged-support end 10111 of the beam structure 1011 and the length of the beam structure 1011 when the first-order resonance valley and the third-order resonance peak of the beam structure 1011 cancel each other may be about 0.33 or 0.67.

In some embodiments, the first position that makes the first-order resonance valley and the third-order resonance peak cancel each other may also be determined as the vibration output position of the beam structure 1011 such that the acoustic output apparatus may achieve a peak and valley cancellation. Correspondingly, the acoustic output apparatus may have a first resonance peak, a second resonance peak, and a third resonance peak in part of the audible domain of the human ear (e.g., 50 Hz-15000 Hz). At this time, as the first-order resonance valleys move to higher frequencies, the first resonance peak may smoothly transition to the second resonance peak, the second resonance peak may smoothly transition to the third resonance peak, and a smooth curve in a wider frequency range may be obtained, which may improve the sound quality of the acoustic output apparatus. Merely by way of example, the ratio of the frequency of the second resonant peak to the frequency of the first resonant peak may be greater than 10. In some embodiments, to obtain a smooth curve between the first resonance peak and the second resonance peak in a wider frequency range, i.e., the first-order resonance valley and the third-order resonance peak of the beam structure 1011 cancel each other, the ratio between the distance from the first position to one of the two hinged-support ends and the length of the beam structure 1011 may be in a range from 0.3 to 0.4. In some embodiments, the ratio between the distance from the first position to one of the two hinged-support ends 10111 and the length of the beam structure 1011 may be in a range from 0.3 to 0.37. In some embodiments, the ratio between the distance from the first position to one of the two hinged-support ends 10111 and the length of the beam structure 1011 may be in a range from 0.31 to 0.35.

FIG. 11A is a schematic diagram illustrating an exemplary structure of a beam structure according to some embodiments of the present disclosure. The beam structure 1111 shown in FIG. 11A may be substantially the same as the beam structure 211 shown in FIG. 2. A difference between the beam structure 1111 and the beam structure 211 may include that the beam structure 1111 shown in FIG. 11A includes a fixed end 11111 and a fixed end 11112. As shown in FIG. 11A, the two fixed ends may be two ends of the beam structure 1111 that are away from each other along the length direction (x-direction as shown in FIG. 11A). The fixed ends may be similar to the fixed end 2111.

In some embodiments, for the beam structure 1111 as shown in FIG. 11A, the first position may be determined such that the frequency response curve of the acoustic output apparatus may achieve a peak and valley cancellation, which may increase the range of the smooth curve of the frequency response curve of the acoustic output apparatus in the audible domain of the human ear, thereby improving the sound quality of the acoustic output apparatus. In some embodiments, the intrinsic vibration function of the beam structure 1111 obtained after substitution of the boundary conditions may be expressed as:

$$Y_i(x) = sin(\beta_i x) - sh(\beta_i x) + \frac{sin(\beta_i l) - sh(\beta_i l)}{ch(\beta_i l) - cos(\beta_i l)}[cos(\beta_i x) - ch(\beta_i x)], \qquad (6)$$

where, $\beta_i$ satisfies: $cos(\beta_i l) * ch(\beta_i l) = 1$, the $\beta_i l$ value of each order may be obtained as $\beta_1 l = 4.73$, $\beta_2 l = 7.85$, $\beta_3 l = 10.99......$ After substituting the $\beta_i l$ value into equation (6), a solution of equation (6) when $Y_i(x)=0$ may be obtained as the ratio between the distance from the first position that makes the peak and valley cancellation of each order occurs to the fixed end 11111 and the length of the beam structure 1111. Merely by way of example, when the beam structure 1111 is driven by piezoelectricity, even-order resonance modes of the beam structure 1111 with symmetric boundary conditions may disappear, leaving only odd-order resonance peaks. According to equation (6), the ratio between the distance from the first position that makes the first-order resonance valley and the third-order resonance peak of the beam structure 1111 cancel each other to one of the fixed ends and the length of the beam structure 1111 may be about 0.36 or 0.64.

In some embodiments, the beam structure 1111 including the fixed end 11111 and the fixed end 11112 may be a symmetrical structure at two ends, i.e., the beam structure 1111 may be symmetrical along the axis L, where L may pass through the midpoint O and be parallel to the width direction y of the beam structure 1111. In some embodiments, the electrodes of the piezoelectric layers on the beam structure 1111 may also be symmetrical along the axis L. In such cases, when the beam structure 1111 vibrates, the stresses on the beam structure 1111 on both sides of the axis L may be distributed symmetrically, and the rotation angle of the midpoint O may be 0. The rotation angle of a point described here may refer to an angular displacement of a cross section of the beam structure where the point is located around a neutral axis (e.g., the x-axis or z-axis shown in FIG. 11A) when the beam structure vibrates (or deforms). FIG. 11B is a schematic diagram illustrating vibration modes of the beam structure in FIG. 11A. As shown in FIG. 11B, (a), (b), and (c) in FIG. 11B denote first-order, third-order, and fifth-order vibration mode curves of the beam structure 1111, respectively. The first-order, third-order, and fifth-order vibration modal curves may correspond to the first-order, third-order, and fifth-order vibration functions $Y_1$, $Y_1$, and $Y_5$ of equation (6), respectively. The horizontal axis denotes points of the beam structure 1111 and the vertical axis denotes the intrinsic vibration function $Y_i(x)$ of the beam structure 1111, and an intersection point of the vibration mode curve with the horizontal axis (i.e., $Y_i(x) = 0$) may be a vibration node. It should be noted that due to the symmetric distribution of stresses on both sides of the midpoint O, the rotation angle of the midpoint O may be 0. Correspondingly, when the beam structure 1111 is driven by piezoelectricity, even-order resonance modes of the beam structure may disappear, leaving only odd-order resonance modes. In such cases, as shown in FIG. 11B, the actual vibration of the beam structure 1111 may not include even-order vibration modes (e.g., the frequency response curve of the beam structure 1111 may not include the second-order peak, the second-order valley, the fourth-order peak, the fourth-order valley, etc.). Further according to (a), (b), and (c) in FIG. 11B, the vibration function $Y_i(x)$ may not intersect the transverse axis at the midpoint O. Thus, the midpoint O of the beam structure 1111 may not be the vibration node of the beam structure 1111, or it may not be a point that makes the peak and valley cancellation occur.

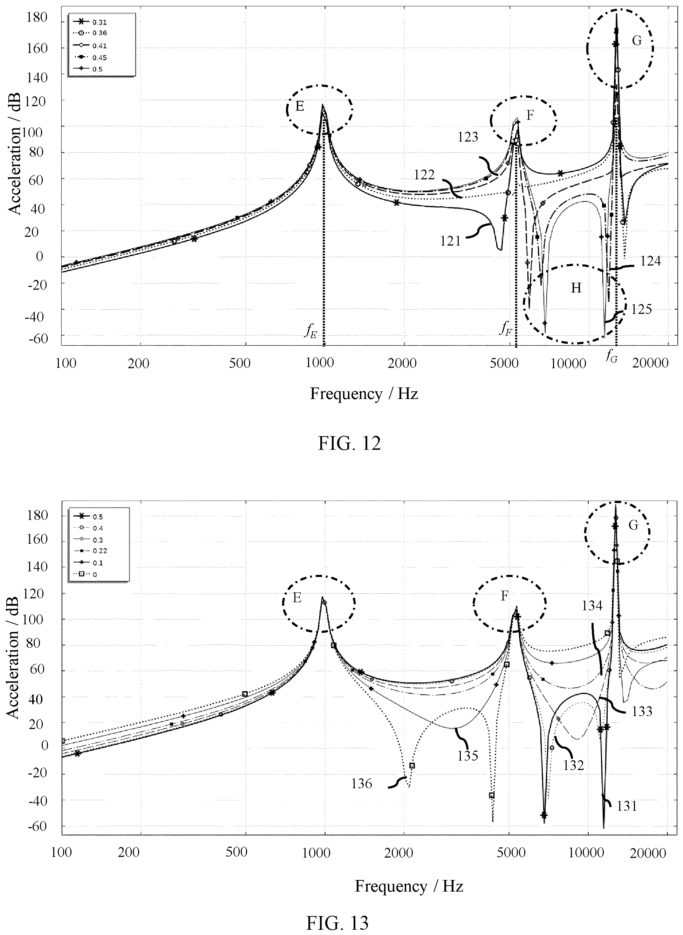

FIG. 12 is a graph illustrating vibration response curves of a beam structure at different points along a length direction of the beam structure according to some embodiments of the present disclosure. As shown in FIG. 12, curves 121, 122, 123, 124, and 125 are respectively the vibration response curves of five position points on the beam structure 1111 shown in FIG. 11A when the ratios between the distances from the five position points to one fixed end and the length of the beam structure 1111 are 0.31, 0.36 (i.e., a theoretical first position that makes the first-order resonance valley and the third-order resonance peak cancel each other), 0.41, 0.45 and 0.5. The frequency response curves of the five position points may denote the frequency response curves of the acoustic output apparatus when the mass element is connected to the five position points, respectively.

According to FIG. 12, in the range of 50 Hz-20000 Hz, the frequency response curves corresponding to the five position points may have a plurality of resonance peaks (e.g., a resonance peak E, a resonance peak F, a resonance peak G, etc.). And when the vibration output point (the first position) moves from the midpoint to the fixed end, the frequency response curves show that the frequency position of each resonance peak may be basically unchanged, and the resonance valleys gradually move from high to low frequency. A ratio between a frequency $f_E$ corresponding to the resonance peak E, a frequency $f_F$ corresponding to the resonance peak F, and a frequency $f_G$ corresponding to the resonance peak G may be approximately:

$f_E$:$f_F$:$f_G$ = 1: 5.36: 13.06. The resonance frequencies corresponding to each order on the beam structure 1111 may be expressed as:

$$f_i = \frac{1}{2\pi}(\beta_i l)^2 * \sqrt{\frac{\Sigma(EI)}{\rho l^4}}, \qquad (7)$$

according to equation (7), a ratio between a frequency $f_1$ corresponding to the first-order resonance peak, $f_3$ corresponding to the third-order resonance peak, and $f_5$ corresponding to the fifth-order resonance peak of the beam structure 1111 may be: $f_1$:$f_3$:$f_5$ = $(\beta_1 l)^2$:$(\beta_3 l)^2$:$(\beta_5 l)^2$. Further according to equation (6), the $\beta_i l$ value of each order may be obtained: $f_1$:$f_3$:$f_5$ = 1:5.40: 13.35. According to a comparison of $f_1$:$f_3$:$f_5$ and $f_E$:$f_F$:$f_G$, the resonance peak E, resonance peak F, and resonance peak G may be the first-order resonance peak, the third-order resonance peak, and the fifth-order resonance peak, respectively, and the vibration of the beam structure 1111 may not include the even-order vibration mode.

Further, as shown by curve 122, the resonance valley and the third-order resonance peak F may cancel each other when the resonance valley moves to a position near the frequency corresponding to the third-order resonance peak F and a smooth curve in a wider frequency band between the first-order resonance peak E and the fifth-order resonance peak G (in the range of 1000 Hz-13000 Hz) may be obtained. In such cases, in some embodiments, the first position may be adjusted such that the first-order resonance valley and the third-order resonance peak of the beam structure 1111 may cancel each other. In such cases, the frequency response curve of the acoustic output apparatus may have a first resonance peak (i.e., the first-order resonance peak E) and a second resonance peak (i.e., the fifth-order resonance peak G), a ratio of a frequency of the second resonance peak to a frequency of the first resonance peak may be greater than 13 (e.g., $f_1$:$f_5$ = 1: 13.35), and a smooth curve in a wider frequency band between the first resonance peak and the second resonance peak may be obtained, thereby improving the sound quality of the acoustic output apparatus. According to equation (6) and FIG. 12, in some embodiments, the ratio between the distance from the first position to one of the two fixed ends and the length of the beam structure 1111 may be in a range from 0.3 to 0.4. In some embodiments, the ratio between the distance from the first position to one of the two fixed ends and the length of the beam structure 1111 may be in a range from 0.32 to 0.4. In some embodiments, the ratio between the distance from the first position to one of the two fixed ends and the length of the beam structure 1111 may be in a range from 0.34 to 0.38.

In addition, according to curves 123, 124, and 125, the frequency response curves of the vibration output point near the midpoint of the beam structure 1111 may have a large resonance valley(s) (e.g., a resonance valley H in Fig. 12) A cause of the large resonance valley may include that the beam structure 1111 generates a curl mode in the width direction (e.g., the y direction shown in Fig. 11A), and the curl mode affects the amplitude of the resonance valley of the frequency response curve. Further according to curve 125, the first position may be adjusted to a position near the midpoint of the length direction of the beam structure 1111such that, when the effect of the curl mode is ignored, the frequency response curve of the acoustic output apparatus may have a first resonance peak (i.e., the first-order resonance peak E), a second resonance peak (i.e., the third-order resonance peak F), and a third resonance peak (i.e., the fifth-order resonance peak G), wherein the first-order resonance peak E may smoothly transition to the third-order resonance peak F, and the third-order resonance peak F may smoothly transition to the fifth-order resonance peak G, which may improve the sound quality of the acoustic output apparatus. Merely by way of example, as shown in FIG. 12, the amplitude difference between the minimum frequency response between the second resonance peak and the third resonance peak and the second resonance peak or the third resonance peak may be less than 40 dB, the ratio of the frequency between the third resonance peak and the frequency of the second resonance peak may be greater than 2, and the second resonance peak may smoothly transition to the third resonance peak. In some embodiments, the ratio between the distance from the first position to one of the two fixed ends and the length of the beam structure 1111 may be in a range from 0.45 to 0.5.

FIG. 13 is a graph illustrating vibration response curves of a beam structure at different position points along a width direction of the beam structure according to some embodiments of the present disclosure. As shown in FIG. 13, curve 131, curve 132, curve 133, curve 134, curve 135, and curve 136 are respectively the frequency response curves of six position points on the beam structure 1111 shown in FIG. 11A when the ratios between the distances from the six position points to a side edge 11113 of the beam structure 1111 and the width of the beam structure 1111 are 0.5, 0.4, 0.3, 0.22, 0.1, and 0. The side edge 11113 may be one of the two sides perpendicular to the width direction of the beam structure 1111. And all of the six position points are the midpoints in the length direction. In the six curves, curve 134 is smoother than the others, wherein on curve 134, the first-order resonance peak E smoothly transitions to the third-order resonance peak F, and the third-order resonance peak F smoothly transitions to the fifth-order resonance peak G.

The curl mode in the width direction on the beam structure 1111 may be approximated as the first-order vibration mode of the beam structure with free ends at both ends. The first-order intrinsic vibration function may be expressed as:

$$Y(x') = sin\left(\frac{\pi x'}{L}\right) - \frac{2}{\pi}, \qquad (8)$$

where $x'$ denotes a distance from a point on the beam structure 1111 to the edge side 1113, and $L$ denotes the width of the beam structure. Let $(x') = 0$ and a vibration node $x'/L = 0.22$ of the curl mode may be obtained. According to FIG. 13, the curl mode in the width direction may be eliminated at the vibration node.

Accordingly, to eliminate the curl mode in the width direction and to improve the resonance valley with small amplitude, in some embodiments, along the width direction of the beam structure, the ratio between the distance from the first position to one side of the beam structure 1111 and the width of the beam structure 1111 may be in a range from 0.1 to 0.4. In some embodiments, along the width direction of the beam structure, the ratio between the distance from the first position to one side of the beam structure 1111 and the width of the beam structure 1111 may be in a range from 0.15 to 0.3. In some embodiments, along the width direction of the beam structure, the ratio between the distance from the first position to one side of the beam structure 1111 and the width of the beam structure 1111 may be in a range from 0.18 to 0.36.

FIG. 14A is a schematic diagram illustrating an exemplary structure of a beam structure according to some embodiments of the present disclosure. The beam structure 1411 shown in FIG. 14A may be substantially the same as the beam structure 1111 shown in FIG. 11A. A difference between the beam structure 1411 and the beam structure 1111 may include that the beam structure 1411 shown in FIG. 14A includes an elastic end 14111 and an elastic end 14112. As shown in FIG. 14A, the elastic end 14111 and the elastic end 14112 may be respectively two ends of the beam structure 1411 that are away from each other. In some embodiments, the two elastic ends may be connected to other components of the acoustic output apparatus (e.g., a fixed support of the beam structure, a housing, etc.) through an elastic member(s) 1412.

The elastic member 1412 may be a member with elasticity. In some embodiments, the elastic member 1412 may have an elastic structure. Exemplary elastic structures may include a continuous bending structure, a helical structure, a leaf spring structure, a mechanical spring, a gas spring, an electromagnetic spring, etc., or any combination thereof. In some embodiments, the elastic member 1412 may be made of an elastic material. Exemplary elastic materials may include a foam, a rubber, a latex, a silicone, a sponge, etc., or any combination thereof. In some embodiments, the beam structure 1411 may be a symmetrical structure at both ends. The elastic members 1412 corresponding to the elastic end 14111 and the elastic end 14112 may be disposed symmetrically along the length direction and/or width direction of the beam structure.

In some embodiments, for structural stability, the elastic end 14111 may be connected to other components of the acoustic output apparatus through at least two elastic members 1412. In some embodiments, at least two elastic members 1412 may be symmetrically distributed along the beam structure 1411.

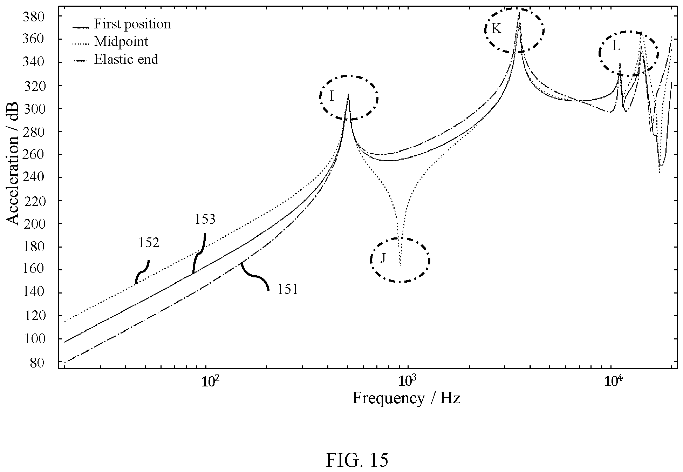

FIG. 14B is a schematic diagram illustrating vibration modes of the beam structure in FIG. 14A. As shown in FIG. 14B, (a)-(e) denote the vibration mode curves of the beam structure 1411 in different vibration modes, respectively. (a) shows an initial vibration mode of the beam structure 1411. In the initial vibration mode, the beam structure 1411 starts to be driven by piezoelectricity, vibrates in the middle first and further drives the elastic members 1412 on both sides to vibrate. As the frequency increases, as shown in (b), the elastic mass formed by the beam structure 1411 and the elastic member 1412 resonates, and the resonance generates a first resonance peak. In some embodiments, a resonance frequency corresponding to the first resonance peak may be between 300 Hz and 700 Hz. Merely by way of example, the frequency response curve of the beam structure 1411 shown in FIG. 15 has a first resonance peak I at about 500 Hz. Further, as the frequency increases, the middle of the vibration mode curve shown in (c) sinks, and the midpoint of the vibration mode curve intersects the transverse axis. Correspondingly, the midpoint of the beam structure 1411 forms a vibration node, and the frequency response curve corresponding to the midpoint may have a resonance valley (e.g., a resonance valley J as shown in FIG. 15). As the frequency continues to increase, the beam structure 1411 resonates at its intrinsic resonance frequency and the resonance generates a second resonance peak. (d) shows a resonance mode of the beam structure 1411. In the resonance mode, the beam structure 1411 resonates near the resonance frequency. In some embodiments, the resonance frequency may be between 3300 Hz and 4300 Hz. Merely by way of example, the frequency response curve of the beam structure 1411 shown in FIG. 15 has a second resonance peak K at about 3800 Hz. In the resonance mode, the middle part of the vibration mode curve continues to sink and has two intersections with the horizontal axis near the ends. Correspondingly, the beam structure 1411 forms vibration nodes at the two intersections, and the corresponding frequency response curve may have resonance valleys. As the frequency continues to increase, the beam structure 1411 resonates at another intrinsic resonance frequency. The resonance generates a third resonance peak. (e) shows the resonance mode of the beam structure 1411 at another intrinsic resonance frequency. In the resonance mode, the beam structure 1411 resonates near another resonance frequency. In some embodiments, the resonance frequency may be between 12 kHz and 18 kHz. Merely by way of example, the frequency response curve of the beam structure 1411 shown in FIG. 15 has a third resonance peak L at about 15,000 Hz. In the resonance mode shown in (e), the middle part and two ends of the vibration mode curve sink and have four intersections with the horizontal axis. Correspondingly, the beam structure 1411 forms vibration nodes at the four intersections, and the corresponding frequency response curves may have resonance valleys. According to FIG. 14B, in the vibration modes shown in (a)-(e), positions on the beam structure 1411 near the elastic end (e.g., between the dashed lines L1 and L2, and between the dashed lines L3 and L4) always have no node. Correspondingly, in the vibration modes shown in (a)-(e), the frequency response curves corresponding to the positions near the elastic end always have no resonance valley, and the curve between each resonance peak (e.g., between the first resonance peak I and the second resonance peak K, or between the second resonance peak K and the third resonance peak L) may be smoothly transitioned. In such cases, the positions near the elastic end may be determined as the first positions such that the curve between the resonance peaks of the acoustic output apparatus may be smoothly transitioned, thereby improving the sound quality of the acoustic output apparatus. In some embodiments, to obtain smooth transition curves between the resonance peaks of the acoustic output apparatus, the ratio between the distance from the first position to one of the elastic ends and the length of the beam structure 1411 may be in a range from 0.1 to 0.25. In some embodiments, the ratio between the distance from the first position to one of the elastic ends and the length of the beam structure 1411 may be in a range from 0.15 to 0.2.

FIG. 15 is a graph illustrating vibration response curves of a beam structure at different points on the beam structure according to some embodiments of the present disclosure. As shown in FIG. 15, curve 151 is the frequency response curve at the elastic end (e.g., the elastic end 14111 or 14112) on the beam structure 1411, curve 152 is the frequency response curve at the midpoint on the beam structure 1411, and curve 153 is the frequency response curve at the first position on the beam structure 1411. A ratio between the distance from the first position to one of the elastic ends (e.g., the elastic end 14111) and the length of the beam structure 1411 is 0.2. According to curves 151-153, the frequency response curve of the acoustic output apparatus may have no or small resonance valleys in the frequency range of 500 Hz-15000 Hz when the output position is the elastic end or the first position, and the curve between resonance peaks (e.g., between the first resonance peak I and the second resonance peak K, and/or between the second resonance peak K and the third resonance peak L) may be smoothly transitioned, which may generate better frequency response. In addition, according to curve 151 and curve 153, in a low frequency range (e.g., less than 500 Hz), the vibration at the first position may have a higher amplitude compared to the elastic end. Therefore, the low frequency sensitivity at the first position may be higher than the low frequency sensitivity at the elastic end. In such cases, the first position to which the mass element is connected on the beam structure 1411 may be close to the elastic end. The ratio between the distance from the first position to one of the elastic ends and the length of the beam structure 1411 may be in a range from 0.15 to 0.2 such that a smooth frequency response curve may be obtained and the low frequency sensitivity of the acoustic output apparatus may be improved.

In some embodiments, the vibration of the elastic mass including the elastic member 1412 and the beam structure 1411 may generate a resonance peak in the lower frequency range, thereby improving the sensitivity of the acoustic output apparatus in the low frequency range. For example, as shown in FIG. 15, curves 151 and 152 have a first resonance peak I in the lower frequency range (e.g., 300 Hz-700 Hz). To make the vibrations of the elastic member 1412 and the beam structure 1411 generate resonance peaks in the lower frequency range, thereby improving the sensitivity of the acoustic output apparatus in the low frequency range, in some embodiments, an equivalent elasticity coefficient of the elastic member 1412 corresponding to the elastic end (e.g., the elastic end 14111 or the elastic end 14112) may be in a range from 3500-4000 N/m. In some embodiments, the equivalent elasticity coefficient of the elastic member 1412 corresponding to the elastic end may be in a range from 3700-3900 N/m.

FIG. 16A is a schematic diagram illustrating an exemplary structure of a beam structure according to some embodiments of the present disclosure. The beam structure 1611 shown in FIG. 16A may be substantially the same as the beam structure 1411 shown in FIG. 14A. A difference between the beam structure 1611 and the beam structure 1411 may include that the beam structure 1611 shown in FIG. 16A has free ends (e.g., a free end 16111 and a free end 16112) at two ends and is connected to a fixed position or structure (e.g., a fixed support) of the acoustic output apparatus through an elastic member 1612 disposed in a middle part of the beam structure 1611. More description regarding the elastic member 1612 may be found elsewhere in the present disclosure. See, e.g., the description regarding the elastic member 1412 in FIG. 14A. As shown in FIG. 16A, one end of the elastic member 1612 may be connected to the middle part of the beam structure, and the other end of the elastic member 1612 may be connected to a fixed position or structure of the acoustic output apparatus. It should be noted that the middle part of the beam structure 1611 may refer to a certain region range near the midpoint of an axis of the beam structure 1611.

In some embodiments, to maintain the structural stability of the beam structure 1611, the elastic members 1612 are disposed on both sides of the beam structure 1611 perpendicular to the axis of the beam structure 1611. In some embodiments, a line connecting the elastic members 1612 on both sides of the beam structure 1611 may be perpendicular to the axis of the beam structure 1611. In some embodiments, the elastic members 1612 on both sides of the beam structure 1611 may also be disposed symmetrically along a midline (e.g., a midline M as shown in FIG. 16A) perpendicular to the axis of the beam structure 1611. In some embodiments, the elastic members 1612 on both sides of the beam structure 1611 may also be spaced at the same distance from the midline (e.g., a midline M as shown in FIG. 16A) perpendicular to the axis of the beam structure 1611.

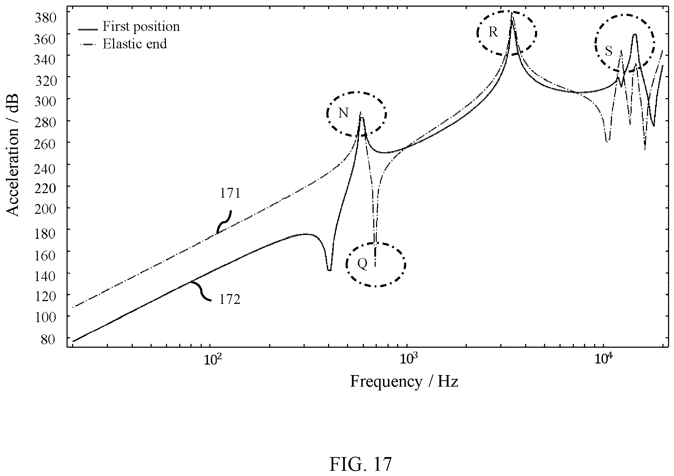

FIG. 16B is a schematic diagram illustrating vibration modes of the beam structure 1611 in FIG. 16A. As shown in FIG. 16B, (a)-(e) denote the vibration mode curves of the beam structure 1611 in different vibration modes, respectively. (a) shows an initial vibration mode of the beam structure 1611. In the initial vibration mode, the beam structure 1611 starts to be driven by piezoelectricity, vibrates at both ends first and the vibration mode curve sinks at both ends. As the frequency increases, as shown in (b), the elastic mass formed by the elastic member 1612 and the beam structure 1611 resonates, and the resonance generates a first resonance peak. In some embodiments, the resonance frequency corresponding to the first resonance peak may be between 400 Hz and 1000 Hz. Merely by way of example, the frequency response curve of the beam structure 1611 shown in FIG. 17 has a first resonance peak N at about 600 Hz. Further, as the frequency increases, two ends of the vibration mode curve as shown in (c) lift upward and the free ends intersect with the horizontal axis.

Correspondingly, the free ends of the beam structure 1611 form vibration nodes, and the frequency response curves corresponding to the free ends may have a resonance valley(s) (e.g., resonance valley Q as shown in FIG. 17). As the frequency continues to increase, the beam structure 1611 resonates at an intrinsic resonance frequency thereof. The resonance generates a second resonance peak. (d) shows a resonance mode of the beam structure 1611. In the resonance mode, the beam structure 1611 resonates near the resonance frequency. In some embodiments, the resonance frequency may be between 3300 Hz and 4300 Hz. Merely by way of example only, the frequency response curve of the beam structure 1611 shown in FIG. 17 has a second resonance peak R at about 3650 Hz. In the resonance mode, the two ends of the vibration mode curve continue to lift upward and generate two intersections with the horizontal axis near the free end, respectively. Correspondingly, the beam structure 1611 forms vibration nodes at the two intersections, and the corresponding frequency response curve may have a resonance valley(s). As the frequency continues to increase, the beam structure 1611 resonates at another intrinsic resonance frequency. The resonance generates a third resonance peak. (e) shows a resonance mode at another intrinsic resonance frequency. In the resonance mode, the beam structure 1611 resonates near the another resonance frequency. In some embodiments, the resonance frequency may be between 12 kHz and 18 kHz. Merely by way of example, the frequency response curve of the beam structure 1611 shown in FIG. 17 has a third resonance peak S around 15,000 Hz. In the resonance mode shown in (e), the middle part of the vibration mode curve and the two free ends sink and generate four intersection points with the horizontal axis. Correspondingly, the beam structure 1611 forms vibration nodes at the four intersections, and the corresponding frequency response curves may have resonance valleys. According to FIG. 16B, in the vibration modes shown in (a)-(e), positions on the beam structure 1611 near the midpoint (e.g., between the dashed lines L5 and L6) always have no node. Correspondingly, in the vibration modes shown in (a)-(e), the frequency response curves corresponding to the positions near the midpoint always have no resonance valley, and the curve between each resonance peak (e.g., between the first resonance peak N and the second resonance peak R, or between the second resonance peak R and the third resonance peak S) may be smoothly transitioned. In such cases, the positions near the midpoint may be determined as the first positions such that the curve between the resonance peaks of the acoustic output apparatus may be transitioned smoothly, thereby improving the sound quality of the acoustic output apparatus. In some embodiments, to obtain smooth transition curves between the resonance peaks of the acoustic output apparatus, the ratio between the distance from the first position to one of the elastic ends and the length of the beam structure 1611 may be in a range from 0.3 to 0.7. In some embodiments, the ratio between the distance from the first position to one of the elastic ends and the length of the beam structure 1611 may be in a range from 0.4 to 0.6.

FIG. 17 is a graph illustrating vibration response curves of a beam structure at different points on the beam structure according to some embodiments of the present disclosure. As shown in FIG. 17, curve 171 is the frequency response curve at a free end (e.g., the free end 16111 or 16112) on the beam structure 1611, and curve 172 is the frequency response curve at a first position on the beam structure 1611. The ratio between the distance from the first position to one of the free ends (e.g., the free end 16111) and the length of the beam structure 1611 is 0.45. According to curves 171 and 172, when the output position is the first position, the frequency response curve of the acoustic output apparatus has no or small resonance valleys in the frequency range of 500 Hz-15000 Hz, and the curve between resonance peaks (e.g., between the first resonance peak N and the second resonance peak R, and/or between the second resonance peak R and the third resonance peak S) may be smoothly transitioned, which may generate better frequency response. In such cases, the first position to which the mass element is connected on the beam structure 1611 may be close to the midpoint of the beam structure 1611. The ratio between the distance from the first position to one of the elastic ends and the length of the beam structure 1611 may be in a range from 0.4 to 0.6 such that a smooth frequency response curve may be obtained and the sound quality of the acoustic output apparatus may be improved.

FIG. 18 is a partial schematic diagram illustrating an acoustic output apparatus according to some embodiments of the present disclosure. As shown in FIG. 18, the acoustic output apparatus may include a beam structure 1811 and a second beam structure 1821. In some embodiments, the beam structure 1811 may be the same as or similar to the second beam structure 1821. The beam structure 1811 and the second beam structure 1821 may be similar to the beam structure 211 shown in FIG. 2. More description regarding the beam structure 1811 and the second beam structure 1821 may be found in FIG. 2.

As shown in FIG. 18, one end of the beam structure 1811 and one end of the second beam structure 1821 may be fixed ends, and the other end of the beam structure 1811 and the other end of the second beam structure 1821 may be connected to each other through a connection member 1830. In some embodiments, the connection member 1830 may be an elastic connection member. In some embodiments, the elastic connection member may be an elastic structure.

FIG. 19 is a schematic diagram illustrating an acoustic output apparatus according to some embodiments of the present disclosure. As shown in FIG. 19, the acoustic output apparatus may include two or more vibration elements. Each vibration element may include a beam structure 1911. The beam structure 1911 may include a fixed end 19111 and a free end 19112. A plurality of beam structures 1911 may be disposed at intervals around the circumference of the mass element 1920. The mass element 1920 may be connected to first positions 19113 of the plurality of beam structures 1911, respectively. In some embodiments, the mass element 1920 may include a vibration plate, a diaphragm, etc. such that the acoustic output apparatus may output a vibration through the mass element 1920. The beam structure 1911 may be similar to the beam structure 211 shown in FIG. 2. More description regarding the beam structure 1911 may be found in FIG. 2.

In some embodiments, the plurality of beam structures 1911 may be symmetrically distributed around the circumference of the mass element 1920 along the midpoint of the mass element 1920. In some embodiments, the plurality of beam structures 1911 may be disposed evenly at intervals around the circumference of the mass element 1920. In some embodiments, the ratios between the distances from the first positions to which the mass element 1920 is connected on the plurality of beam structures 1911 to the fixed ends 19111 of the beam structures 1911 and the lengths of the beam structures 1911 may be the same. In some embodiments, the first position 19113 may be determined based on the descriptions in other embodiments (e.g., FIG. 3, etc.) of the present disclosure such that the frequency response curve of the mass element 1920 (or acoustic output apparatus) may achieve peak and valley cancellation, and a smooth curve in a wider frequency band may be obtained, thereby improving the sound quality of the acoustic output apparatus. In some embodiments, to make the first-order resonance valley and the second-order resonance peak on the frequency response curve of the mass element 1920 cancel each other such that a smooth curve in a wide frequency band between the first resonance peak and the second resonance peak of the acoustic output apparatus may be obtained, thereby improving the sound quality of the acoustic output apparatus, the ratio between the distance from the first position to which the mass element 1920 is connected on each beam structure 1911 to the fixed end 19111 of the beam structure 1911 and the length of the beam structure may be in a range from 0.75 to 0.95. In some embodiments, the ratio between the distance from the first position to which the mass element 1920 is connected on each beam structure 1911 to the fixed end 19111 of the beam structure 1911 and the length of the beam structure may be in a range from 0.8 to 0.85. In some embodiments, to make the first-order resonance valley and the third-order resonance peak on the frequency response curve of the mass element 1920 cancel each other such that a smooth curve in a wider frequency band between the second resonance peak and the third resonance peak of the acoustic output apparatus may be obtained, thereby improving the sound quality of the acoustic output apparatus, the ratio between the distance from the first position to which the mass element 1920 is connected on each beam structure 1911 to the fixed end 19111 of the beam structure 1911 and the length of the beam structure may be in a range from 0.45 to 0.6. In some embodiments, the ratio between the distance from the first position to which the mass element 1920 is connected on each beam structure 1911 to the fixed end 19111 of the beam structure 1911 and the length of the beam structure may be in a range from 0.5 to 0.55.

It should be noted that the vibration elements or the beam structures shown in FIGs. 2-19 are for description purposes only and are not intended to limit the scope of the present disclosure. The possible beneficial effects vary from embodiment to embodiment, and in different embodiments, the possible beneficial effects can be any one or a combination of the above, or any other beneficial effect that may be obtained.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements and amendments to the present disclosure. These alterations, improvements, and modifications are intended to be suggested by this disclosure, and are within the spirit and scope of the exemplary embodiments of this disclosure.

Moreover, certain terminology has been used to describe embodiments of the present disclosure. For example, the terms "one embodiment," "an embodiment," and/or "some embodiments" mean that a particular feature, structure or characteristic described in connection with the embodiment is included in at least one embodiment of the present disclosure. Therefore, it is emphasized and should be appreciated that two or more references to "an embodiment" or "one embodiment" or "an alternative embodiment" in various portions of this specification are not necessarily all referring to the same embodiment. In addition, some features, structures, or features in the present disclosure of one or more embodiments may be appropriately combined.

In addition, unless expressly stated in the claims, the order in which this present disclosure handles elements and sequences, the use of numeric letters, or the use of other names is not intended to qualify the order of the processes and methods of this present disclosure. Although the above disclosure discusses through various examples what is currently considered to be a variety of useful embodiments of the disclosure, it is to be understood that such detail is solely for that purpose, and that the appended claims are not limited to the disclosed embodiments, but, on the contrary, are intended to cover modifications and equivalent arrangements that are within the spirit and scope of the disclosed embodiments. For example, although the implementation of various components described above may be embodied in a hardware device, it may also be implemented as a software only solution, e.g., an installation on an existing server or mobile device.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that the present disclosure object requires more features than the features mentioned in the claims. Rather, claimed subject matter may lie in less than all features of a single foregoing disclosed embodiment.

In some embodiments, the numbers expressing quantities, properties, and so forth, used to describe and claim certain embodiments of the application are to be understood as being modified in some instances by the term "about," "approximate," or "substantially." Unless otherwise noted, "approximately", " roughly" or "substantially" indicate that $\pm 20\%$ variation is allowed in the figures. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the present disclosure are approximations, the numerical values set forth in the specific examples are reported as precisely as practicable.

Each patent, patent application, patent application publication and other materials cited herein, such as articles, books, instructions, publications, documents, etc., are hereby incorporated by reference in their entirety. In addition to the application history documents that are inconsistent or conflicting with the contents of the present disclosure, the documents that may limit the widest range of the claim of the present disclosure (currently or later attached to this application) are excluded from the present disclosure. It should be noted that in the event of any inconsistency or conflict between the descriptions, definitions, and/or use of terms in the subsidiary materials of this present disclosure and the contents of this present disclosure, the descriptions, definitions, and/or use of terms in this present disclosure shall prevail.

Finally, it should be understood that the embodiments in this present disclosure are used only to illustrate the principles of the embodiments of this present disclosure. Other modifications that may be employed may be within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

## Claims

1. An acoustic output apparatus, comprising:
   a vibration element, the vibration element including a beam structure extending in a length direction, and the beam structure including:

   a piezoelectric layer configured to deform in response to an electrical signal, the deformation driving the vibration element to vibrate; and
   a mass element, the mass element being connected to a first position of the beam structure, and the vibration of the vibration element driving the mass element to vibrate in a direction perpendicular to the length direction, wherein a ratio between a distance from the first position to one end of the beam structure and a length of the beam structure is in a range from 0.3 to 0.95 along the length direction of the beam structure.

2. The acoustic output apparatus of claim 1, wherein the vibration of the mass element includes a first resonance peak and a second resonance peak in a range from 50 Hz to 10000 Hz.

3. The acoustic output apparatus of claim 2, wherein an amplitude difference between a minimum frequency response between the first resonance peak and the second resonance peak and the first resonance peak or the second resonance peak is less than 40 dB.

4. The acoustic output apparatus of claim 3, wherein the beam structure includes a fixed end and a free end.

5. The acoustic output apparatus of claim 4, further including a second mass element, the second mass element being connected to the free end.

6. The acoustic output apparatus of claim 5, wherein a ratio between a mass of the mass element and a mass of the beam structure is in a range from 0 to 1.2.

7. The acoustic output apparatus of claim 6, wherein a ratio between a distance from the first position to the fixed end and a length of the beam structure is in a range from 0.7 to 0.95.

8. The acoustic output apparatus of claim 7, wherein a ratio between a frequency of the second resonance peak and a frequency of the first resonance peak is greater than 17.

9. The acoustic output apparatus of claim 4, wherein the vibration of the mass element includes a third resonance peak, wherein an amplitude difference between a minimum frequency response between the second resonance peak and the third resonance peak and the second resonance peak or the third resonance peak is less than 30 dB.

10. The acoustic output apparatus of claim 9, wherein a ratio between a frequency of the third resonance peak and a frequency of the second resonance peak is greater than 4.

11. The acoustic output apparatus of claim 10, wherein a ratio between a distance from the first position to the fixed end and a length of the beam structure is in a range from 0.45 to 0.6.

12. The acoustic output apparatus of claim 3, wherein the beam structure includes two fixed ends.

13. The acoustic output apparatus of claim 12, wherein a ratio between a distance from the first position to one of the two fixed ends and a length of the beam structure is in a range from 0.3 to 0.4.

14. The acoustic output apparatus of claim 13, wherein a ratio of a frequency of the second resonance peak to a frequency of the first resonance peak is greater than 13.

15. The acoustic output apparatus of claim 12, wherein the vibration of the mass element includes a third resonance peak, wherein an amplitude difference between a minimum frequency response between the second resonance peak and the third resonance peak and the second resonance peak or the third resonance peak is less than 40 dB.

16. The acoustic output apparatus of claim 15, wherein a ratio of a frequency of the third resonance peak to a frequency of the second resonance peak is greater than 2.

17. The acoustic output apparatus of claim 16, wherein a ratio between a distance from the first position to one of the two fixed ends and a length of the beam structure is in a range from 0.45 to 0.5.

18. The acoustic output apparatus of claim 12, wherein a ratio between a distance from the first position to one side of the beam structure and a width of the beam structure in a width direction of the beam structure is in a range from 0.15 to 0.3.

19. The acoustic output apparatus of claim 3, wherein the beam structure includes a fixed end and a hinged-support end, wherein during the vibration of the vibration element, the hinged-support end rotates along an axis perpendicular to the length direction and the vibration direction of the beam structure.

20. The acoustic output apparatus of claim 19, wherein a ratio between a distance from the first position to the fixed end and the length of the beam structure is in a range from 0.5 to 0.6.

21. The acoustic output apparatus of claim 20, wherein a ratio between a frequency of the second resonance peak and a frequency of the first resonance peak is greater than 6.

22. The acoustic output apparatus of claim 3, wherein the beam structure includes two hinged-support ends, wherein during the vibration of the vibration element, the two hinged-support ends rotate along an axis perpendicular to the length direction and the vibration direction of the beam structure, respectively.

23. The acoustic output apparatus of claim 11, wherein a ratio between a distance from the first position to one of the two hinged-support ends and the length of the beam structure is in a range from 0.3 to 0.4.

24. The acoustic output apparatus of claim 12, wherein a ratio of a frequency of the second resonance peak to a frequency of the first resonance peak is greater than 10.

25. The acoustic output apparatus of claim 3, wherein the beam structure includes two elastic ends, the two elastic ends being elastically connected to a fixed support of the acoustic output apparatus via elastic members, respectively.

26. The acoustic output apparatus of claim 25, wherein the beam structure is a symmetrical structure at both ends, the elastic members corresponding to the two elastic ends being disposed symmetrically along the length direction or the width direction of the beam structure.

27. The acoustic output apparatus of claim 26, wherein a frequency range of the first resonance peak is in a range from 300 Hz to 700 Hz.

28. The acoustic output apparatus of claim 26, wherein a ratio between a distance from the first position to one of the two elastic ends and the length of the beam structure is in a range from 0.1 to 0.25.

29. The acoustic output apparatus of claim 3, further including a third vibration element, the third vibration element including a third beam structure, wherein one end of the beam structure and one end of the third beam structure are fixed ends, and the other end of the beam structure is connected to the other end of the third beam structure through an elastic connection member.

30. The acoustic output apparatus of claim 1, wherein a count of the vibration elements is two or more, wherein the beam structure of each of the two or more vibration elements includes a fixed end and a free end.

31. The acoustic output apparatus of claim 30, wherein the mass element is respectively connected to the first position of the beam structure of each of the two or more vibration elements, a ratio between a distance from the first position of each beam structure to the fixed end of the beam structure and the length of the beam structure being in a range from 0.7 to 0.95.

100

Vibration Element 110

Beam Structure 111

Piezoelectric
Layer 1112

Mass Element 120

FIG. 1

**211**

FIG. 2

FIG. 3

411

FIG. 4

FIG. 5

FIG. 6

**711**

FIG. 7

FIG. 8

**911**

FIG. 9

**1011**

FIG. 10

**1111**

FIG. 11A

FIG. 11B

FIG. 12

FIG. 13

FIG. 14A

FIG. 14B

FIG. 15

FIG. 16A

FIG. 16B

FIG. 17

FIG. 18

FIG. 19

## INTERNATIONAL SEARCH REPORT

| | International application No. |
| --- | --- |
| | **PCT/CN2022/108205** |

### A.    CLASSIFICATION OF SUBJECT MATTER

H04R 17/02(2006.01)i;  H04R 9/02(2006.01)i

According to International Patent Classification (IPC) or to both national classification and IPC

### B.    FIELDS SEARCHED

Minimum documentation searched (classification system followed by classification symbols)

H04R

Documentation searched other than minimum documentation to the extent that such documents are included in the fields searched

Electronic data base consulted during the international search (name of data base and, where practicable, search terms used)

CNABS; CNTXT; VEN; WOTXT; USTXT; EPTXT; IEEE; CNKI: 声学, 振动, 压电, 臂, 梁, 质量, 位置, 自由端, 固定端, 弹性, 铰支, 谐振, acoustics, vibration, piezo, arm, beam, mass, position, free, fix, elastic, hinge, resonance

### C.    DOCUMENTS CONSIDERED TO BE RELEVANT

| Category* | Citation of document, with indication, where appropriate, of the relevant passages | Relevant to claim No. |
| --- | --- | --- |
| X | CN 1589064 A (SHENZHEN VOXTECH CO., LTD.) 02 March 2005 (2005-03-02) description, page 3, line 18 to page 6, line 3, and figure 2 | 1-11, 19-23, 25-28 |
| Y | CN 1589064 A (SHENZHEN VOXTECH CO., LTD.) 02 March 2005 (2005-03-02) description, page 3, line 18 to page 6, line 3, and figure 2 | 12-18, 24, 29-31 |
| Y | CN 210958796 U (AAC ACOUSTIC TECHNOLOGIES HOLDINGS INC.) 07 July 2020 (2020-07-07) description, paragraphs [0023]-[0031], and figures 1-5 | 12-18, 24 |
| Y | CN 114697837 A (SHENZHEN VOXTECH CO., LTD.) 01 July 2022 (2022-07-01) description, paragraphs [0173]-[0215], and figures 8-16 | 29-31 |
| X | CN 114466282 A (WUHAN UNIVERSITY) 10 May 2022 (2022-05-10) description, paragraphs [0032]-[0054], and figures 1-2 | 1-11, 19-28 |
| A | CN 114697824 A (SHENZHEN VOXTECH CO., LTD.) 01 July 2022 (2022-07-01) description, paragraphs [0037]-[0067], and figures 1-2 | 1-31 |
| A | CN 111050256 A (WUHAN UNIVERSITY) 21 April 2020 (2020-04-21) entire document | 1-31 |

☑ Further documents are listed in the continuation of Box C.  ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **14 November 2022** | **28 November 2022** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2022/108205** |

**C.      DOCUMENTS CONSIDERED TO BE RELEVANT**

| Category* | Citation of document, with indication, where appropriate, of the relevant passages | Relevant to claim No. |
| --- | --- | --- |
| A | CN 201821288 U (WENZHOU UNIVERSITY) 04 May 2011 (2011-05-04)<br>entire document | 1-31 |
| A | WO 2012145278 A2 (EASTMAN KODAK CO. et al.) 26 October 2012 (2012-10-26)<br>entire document | 1-31 |
| A | US 8552625 B1 (IMAGE ACOUSTICS INC.) 08 October 2013 (2013-10-08)<br>entire document | 1-31 |

Form PCT/ISA/210 (second sheet) (January 2015)

## INTERNATIONAL SEARCH REPORT
### Information on patent family members

| | International application No. |
|---|---|
| | **PCT/CN2022/108205** |

| Patent document cited in search report | | | Publication date (day/month/year) | Patent family member(s) | | | Publication date (day/month/year) |
|---|---|---|---|---|---|---|---|
| CN | 1589064 | A | 02 March 2005 | None | | | |
| CN | 210958796 | U | 07 July 2020 | WO | 2021134202 | A1 | 08 July 2021 |
| CN | 114697837 | A | 01 July 2022 | WO | 2022141828 | A1 | 07 July 2022 |
| | | | | WO | 2022141827 | A1 | 07 July 2022 |
| | | | | WO | 2022141585 | A1 | 07 July 2022 |
| | | | | CN | 114697838 | A | 01 July 2022 |
| CN | 114466282 | A | 10 May 2022 | None | | | |
| CN | 114697824 | A | 01 July 2022 | WO | 2022143302 | A1 | 07 July 2022 |
| | | | | CN | 216391413 | U | 26 April 2022 |
| | | | | CN | 114697779 | A | 01 July 2022 |
| | | | | CN | 114697823 | A | 01 July 2022 |
| | | | | CN | 114697839 | A | 01 July 2022 |
| | | | | WO | 2022140921 | A1 | 07 July 2022 |
| | | | | WO | 2022142291 | A1 | 07 July 2022 |
| | | | | WO | 2022142737 | A1 | 07 July 2022 |
| CN | 111050256 | A | 21 April 2020 | None | | | |
| CN | 201821288 | U | 04 May 2011 | None | | | |
| WO | 2012145278 | A2 | 26 October 2012 | WO | 2012145278 | A3 | 15 August 2013 |
| | | | | US | 2012266686 | A1 | 25 October 2012 |
| | | | | US | 8631711 | B2 | 21 January 2014 |
| US | 8552625 | B1 | 08 October 2013 | None | | | |

Form PCT/ISA/210 (patent family annex) (January 2015)